# EUROPEAN PATENT APPLICATION

(11) **EP 4 753 433 A2**
(43) Date of publication of application: **03.06.2026**
(21) Application number: 26153075.2
(22) Date of filing: 11.02.2022
(51) Int. Cl.: H10K 85/50

(54) **MATERIALS AND METHODS FOR HOLE TRANSPORT LAYERS IN PEROVSKITE PHOTOVOLTAIC DEVICES**

(30) Priority: 12.02.2021 US 202163149083 P
(62) Divisional of application: 22706205.6
(71) Applicant: First Solar, Inc, Tempe, AZ 85288 (US); Alliance for Energy Innovation, LLC, Golden, CO 80401 (US)
(72) Inventor: BERRY, Joseph Jonathan, Golden, CO 80401 (US); CHEN, Le, Perrysburg, OH 43551 (US); PALMSTROM, Axel Finn, Golden, CO 80401 (US); SONG, Tze-Bin, Perrysburg, OH 43551 (US)
(74) Representative: D Young & Co LLP

(57) **Abstract**

Methods and compositions for forming perovskite hole transport layers for use in manufacturing photovoltaic devices are described. Embodiments include using a plurality of hole transport materials to produce high-performance HTL contacts to improve performance and stability.

## Description

### STATEMENT REGARDING FEDERALLY SPONSORED RESEARCH

This invention was made under a Cooperative Research and Development Agreement, CRADA # CRD-13-507, between First Solar, Inc. and The National Renewable Energy Laboratory, operated for the United States Department of Energy. The United States Government has rights in this disclosure under Contract No. DE-AC36-08GO28308 between the United States Department of Energy and Alliance for Sustainable Energy, LLC, the Manager and Operator of the National Renewable Energy Laboratory. The government has certain rights in this invention.

### BACKGROUND

The present specification generally relates to photovoltaic devices, and, more specifically, to the use of particular combinations of materials and layer formation parameters to improve manufacturing processes and the efficiency of perovskite photovoltaic devices.

Organic-inorganic hybrid perovskite solar cells (PSCs) have experienced unprecedented efficiency growth up to 25% certified efficiency within several years of active research, allowing significant progress in realizing a low-cost solution-based process for photovoltaics. Photovoltaic devices generate electrical power by converting light into electricity using semiconductor materials that exhibit the photovoltaic effect. Perovskites (PK) are a class of materials which may form an active layer in photovoltaic devices. Perovskite compounds have an ABX₃ structure, where A and B are cations and X is a halide anion. Materials, including lead halide and tin halide perovskite compounds, have been studied for use in photovoltaic devices. In these structures, the A sites may be composed of one or more cations, such as methylammonium (MA), formamidinium (FA), cesium (Cs⁺), or rubidium (Rb⁺). The B sites may be occupied, for example, by one or more of lead (Pb⁺²), tin (Sn⁺²), or germanium (Ge⁺²) cations. And the X sites may be occupied by one or more halide anions, such as iodine (I⁻), bromine (Br⁻), or chlorine (Cl⁻). In an example photovoltaic device, the perovskite material is positioned in contact with and between an electron charge transport layer (ETL) and a hole charge transport layer (HTL). The hole transporting layer (HTL) is accredited to be an essential component in achieving high efficiency, as it facilitates carrier extraction and reduces carrier recombination. An ideal HTL may include all desired characteristics: (a) matched energy alignment with the valence band (VB) of perovskite absorber; (b) high hole mobility (>10⁻³ cm²/Vs); (c) ability to form uniform and pinhole free layer; (d) low HTL/PK interface recombination; (e) excellent transmittance in visible region; and (f) compatibility with efficient, large-scale manufacturing processes.

Known methods for producing hole charge transport layers only using single materials do not provide all of the features listed above, inevitably limiting the device performance. For example, inorganic hole transporting materials (HTMs), such as NiOx, CuOx, and CuSCN, exhibit high hole mobility (> 0.01 cm²/VS) and low-cost fabrication. But, inorganic materials, especially metals oxides, may chemically react with perovskite, forming structurally defective interfaces and resulting in low open circuit voltage. Organic HTMs generally form a good interface with perovskite and have tunable energy levels. However, due to their low mobility, the overall device performance is very sensitive to the layer thickness, making it challenging for scalable fabrication. Accordingly, a need exists to provide improved processing methods, systems, compositions, and layer structures for efficient and scalable fabrication of charge transport layers for perovskite devices.

### DRAWINGS

The embodiments set forth in the drawings are illustrative and exemplary in nature and not intended to limit the subject matter defined by the claims. The following detailed description of the illustrative embodiments can be understood when read in conjunction with the following drawings, wherein like reference numerals designate identical or corresponding parts throughout the views.
FIG. 1 schematically depicts a cross-sectional view of a N-I-P photovoltaic device.
FIG. 2 schematically depicts a cross-sectional view of a P-I-N photovoltaic device.
FIG. 3 schematically depicts a cross-sectional view of a hole transport layer for a device with an P-I-N stricture according to one or more embodiments shown and described herein.
FIG. 4 schematically depicts a cross-sectional view of a hole transport layer for a device with an N-I-P structure according to one or more embodiments shown and described herein.
FIG. 5 shows a flow chart for an example method.
FIG. 6 shows a flow chart for an example method.
FIGS. 7A and 7B show cross-section SEM images of device layers.
FIGS. 8A and 8B show cross-section SEM images of device layers.
FIG. 9A shows a surface SEM image of a perovskite layer; FIG. 9B shows a cross-section SEM image of device layers; and FIG. 9C shows X-ray diffraction measurement for a perovskite layer.
FIGS. 10A-10D show a comparison of contact angle measurements.
FIGS. 11A-11F show device performance characteristics for experimental structures, and controls, including measurements of efficiency, open-circuit voltage (Voc), fill factor (FF), short-circuit current density (Jsc), open circuit resistance (Roc), and short-circuit conductance (Gsc).
FIGS. 12A-12D show a comparison of performance characteristics using NiO/Organics bilayer for mix-cations PK fabrication with a one-step process.
FIG. 13 shows a comparison of performance characteristics using NiO/Organics bilayer for mix-cations PK fabrication with a two-step process.
FIGS. 14A-14D show a comparison of performance characteristics.

The patent or application file may contain at least one drawing executed in color and/or one or more photographs. Copies of this patent or patent application publication with color drawing(s) will be provided by the Office upon request and payment of the necessary fee.

### DETAILED DESCRIPTION

Perovskite solar cells are fast emerging as efficient low cost alternatives to silicon and other solar cells. However, for better performance and stability of the devices, it is important to select the device components such as the hole and electron transport layers and device architecture. Establishing the device component layers such as the electron transport layer (ETL), the perovskite absorber layer and the hole transport layer (HTL) with respect to proper band alignment, carrier extraction and mobility and contact resistance are crucial for the device performance.

An excellent HTL contact requires an array of material and optoelectronic characteristics for high performance devices, including but not limited to: high hole mobility and conductivity, good energy alignment with adjacent layers, formation of a good interface with the selected perovskite absorber, and robust chemical and thermal stability. However, despite substantial research and development work, no single hole transport material simultaneously achieves all of these objectives.

Embodiments described herein produce high-performance HTL contacts using dual HTL coatings. The inventors have found that selected materials can be combined into a bilayer hole transport layer (HTL) structure that improves reliability and facilitates use of a broader range of processing methods. Specifically, the combination of an inorganic hole transport material and a thinner layer of an organic hole transport material, produced a device with better overall performance and stability than a device with either hole transport material alone and is suitable for use in either N-I-P or P-I-N devices. The HTL bilayer combination had fewer structural defects, improved layer morphology, and lower interface recombination. Devices produced by the methods had good efficiency with improved resistance to surface recombination, and halide-metal reactions. Additionally, in devices having a P-I-N structure, with an inorganic hole transport material overlaid by a thin organic hole transport material, the HTL bilayer contributed to improved perovskite layer formation and uniformity.

Embodiments provide a photovoltaic device with a hole transport layer and methods of forming the layer and the device. Generally, the photovoltaic devices provided herein can include partly-formed or fully-formed photovoltaic modules. Various embodiments of the hole transport layer, the partly-formed photovoltaic structure, and the photovoltaic device, as well as systems and methods for forming the layers, structures, and devices, will be described in more detail herein.

Photovoltaic devices may contain several material layers deposited sequentially over a substrate. Steps for manufacturing a photovoltaic device may include sequentially disposing functional layers or layer precursors in a "stack" of layers through one or more deposition processes, including, but not limited to, spin coating, spray coating, inkjet printing, slot-die coating, blade coating, dip coating, sputtering, evaporation, molecular beam deposition, pyrolysis, closed space sublimation (CSS), pulsed laser deposition (PLD), chemical vapor deposition (CVD), electrochemical deposition (ECD), atomic layer deposition (ALD), molecular layer deposition, thermal evaporation, flash evaporation, or vapor transport deposition (VTD). Manufacturing of photovoltaic devices can further include the selective removal of portions of certain layers of the stack of layers, such as by scribing, to divide the photovoltaic device into a plurality of photovoltaic cells.

Perovskite compounds have an ABX₃ structure, where A and B are cations and X is a halide anion. Specific materials and compounds have been studied for use in photovoltaic devices. In example perovskite structures, the A site may be occupied by one or more of MA, FA, Cs, or Rb. The B site may be occupied by one or more of Pb, Sn, Ge, or other group 14 element. And the X site may be occupied by one or more of I, Cl, Br, or F.

Organic-inorganic or inorganic metal halide perovskite materials can be used to absorb light energy in photovoltaic devices. In a photovoltaic device, the perovskite material is positioned in contact with and between an electron charge transport layer and a hole charge transport layer. Perovskite photovoltaic devices may be configured in either a N-I-P or P-I-N architecture, with either the electron or hole charge transport layer towards the light-incident side of the device.

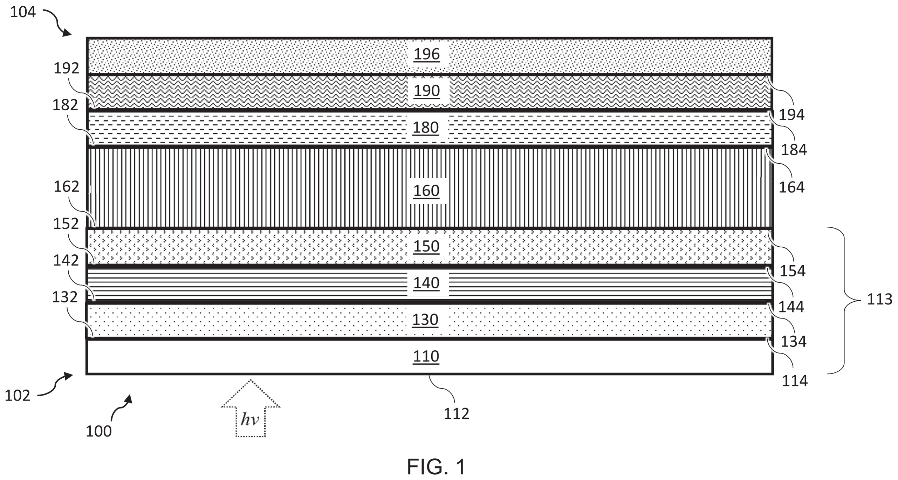

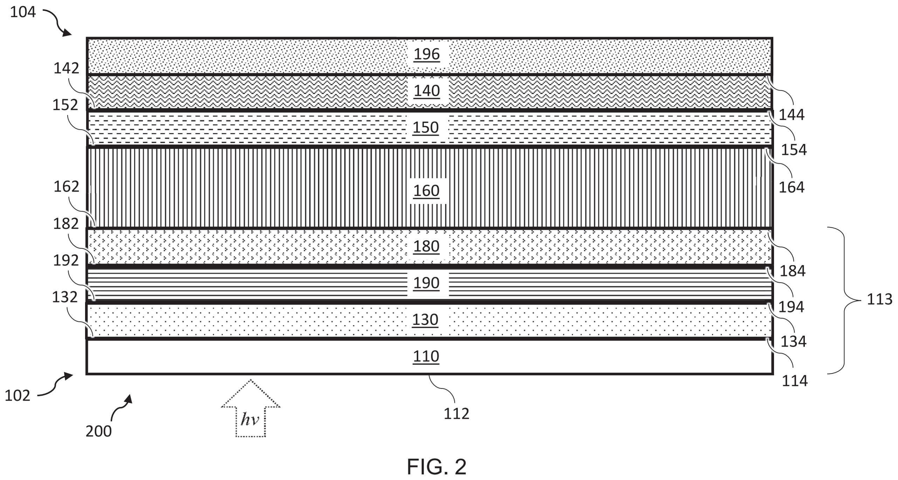

Figures 1 and 2 show example device structures for a perovskite photovoltaic device 100, 200. In FIG. 1, the first depicted example of a device 100, the electron charge transport layer is proximate to the light-incident side, showing a N-I-P structure. In FIG. 2, the second depicted example of a device 200, the hole charge transport layer is proximate to the light-incident side of the device, showing a P-I-N structure.

A photovoltaic device 100, 200 can be configured to receive light and transform light into electrical signals, e.g., photons can be absorbed from the light and transformed into electrical signals via the photovoltaic effect. Accordingly, the photovoltaic device 100, 200 can define an energy, light-incident, or front side 102 configured to be exposed to a light source such as, for example, the sun. The photovoltaic device can also define an opposing side 104 offset from the light-incident side 102 such as, for example, by a plurality of material layers. It is noted that the term "light" can refer to various wavelengths of the electromagnetic spectrum, such as, but not limited to, wavelengths in the ultraviolet (UV), infrared (IR), and visible portions of the electromagnetic spectrum. "Sunlight," as used herein, refers to light emitted by the sun.

The photovoltaic device 100, 200 can include a plurality of layers disposed between the light-incident front side 102 and the opposing side 104. As used herein, the term "layer" refers to a thickness of material provided upon a surface. Each layer can cover all or any portion of the surface. A layer may have sublayers. A layer may have a compositional gradient within the layer across its thickness. In some instances, a transition zone, or region of interdifusion, may be formed at the junction of adjacent layers. The "thickness" of a layer, as used herein, generally describes a measurement across the layer and substantially perpendicular to a planar surface of the light-incident front side 102. A composition having an average atomic percent of an element in the layer, provides a value is representative of the entirety of the layer, however an atomic percentage at a particular location within the layer can be graded through the thickness compared to the overall composition of the layer.

The phrase "adjacent to," as used herein, means that two layers are disposed contiguously and without any intervening materials between all, or at least a portion of, the layers. As used herein, with respect to layer position, the term "over" or "on" describes a fixed relationship between layers, specifying the relative position. The terms "over" or "on," may describe "adjacent" layers, or may more broadly encompass a structure having one or more intermediate layers between the specified layers. As used herein, the terms "over" and "on" are generally used as oriented for forming a superstrate structure, in which, for example, the opposing side 104 would be over the light-incident front side 102. It will be understood that the orientation of a substrate structure is reversed with respect to a superstrate structure. Positional references are made for ease of explanation and to describe relative position. Such terms do not specify positional relationships to a deployed photovoltaic module or to any external environment unless explicitly stated.

In some embodiments, the layers of the photovoltaic device can be divided to form a plurality of photovoltaic cells. For example, the photovoltaic device can be scribed according to a plurality of serial scribes and a plurality of parallel scribes.

The layers of the photovoltaic device 100, 200 can include a substrate 110 configured to facilitate the transmission of light into the photovoltaic device 100. The substrate 110 can be disposed at the front side 102 of the photovoltaic device 100. The substrate 110 can have a first surface 112 substantially facing the energy side 102 of the photovoltaic device 100 and a second surface 114 substantially facing the opposing side 104 of the photovoltaic device 100. One or more layers of material can be disposed between the first surface 112 and the second surface 114 of the substrate 110.

The substrate 110 can be substantially transparent. In some embodiments, the substrate comprises a substantially transparent material such as, for example, glass. Suitable glass can include soda-lime glass, a glass with reduced iron content, or a glass with about 90% transmittance. Optionally, the substrate 110 can include a performance coating applied to form the exterior or light-facing surface. The performance coating can be configured to interact with light or to improve durability of the substrate 110 such as, but not limited to, an antireflective coating, an antisoiling coating, or a combination thereof.

The photovoltaic device 100, 200 can optionally include a barrier layer 130 configured to mitigate diffusion of contaminants from the substrate 110, which could result in degradation or delamination. The barrier layer 130 can have a first surface 132 substantially facing the front side 102 of the photovoltaic device 100 and a second surface 134 substantially facing the opposing side 104 of the photovoltaic device 100. In some embodiments, the barrier layer 130 can be provided adjacent to the substrate 110. For example, the first surface 132 of the barrier layer 130 can be provided upon the second surface 114 of the substrate 100.

The barrier layer 130, when present, may be substantially transparent, thermally stable, with a reduced number of pin holes, having sodium-blocking capability, and/or having good adhesive properties. Alternatively or additionally, the barrier layer 130 can be configured to apply color suppression to light. The barrier layer 130 can include one or more layers of suitable material, including, but not limited to, tin oxide, silicon dioxide, aluminum-doped silicon oxide, silicon oxide, silicon nitride, silicon-oxynitride or aluminum oxide. The barrier layer 130 can have any suitable thickness bounded by the first surface 132 and the second surface 134, including, for example, more than about 100 Å in one embodiment, more than about 150 Å in another embodiment, or less than about 200 Å in a further embodiment. In some embodiments, the barrier layer 130 can be omitted.

The photovoltaic device 100, 200 can include an electrode layer 140 or a n-type contact configured to provide electrical contact to transport electrons, negative charge carriers, generated by the photovoltaic device 100, 200. The electrode layer 140 may function as an anode. The electrode layer 140 can have a first surface 142 substantially facing the energy side 102 of the photovoltaic device 100 and a second surface 144 substantially facing the opposing side 104 of the photovoltaic device 100. In a P-I-N structure, the electrode layer 140 may be referred to as a back contact. In a N-I-P structure, the electrode layer 140 is substantially transparent and may be referred to as a front contact or transparent electrode layer. In some devices with a N-I-P structure, the electrode layer 140 can be provided adjacent to the barrier layer 130 or adjacent to the substrate 110. The electrode layer 140 can be formed from one or more layers of an n-type semiconductor material. The electrode layer 140 may have a wide band gap. Specifically, the wide band gap can have a larger energy value compared to the energy of the photons of the light, which can mitigate undesired absorption of light. The electrode layer 140 can include one or more layers of suitable material, including, but not limited to, tin oxide, tin dioxide, indium tin oxide, or cadmium stannate, and the material may be doped, for example with fluorine.

The photovoltaic device 100, 200 can include an electron transport layer (ETL) 150. The electron transport layer (ETL) may also be called a negative charge transport layer, an electron extraction layer, an electron collection layer, an e⁻ selective contact, or an electron-selective layer. The ETL 150 can have a first surface 152 substantially facing the front side 102 of the photovoltaic device 100, 200 and a second surface 154 substantially facing the opposing side 104 of the photovoltaic device. The ETL 150 may be positioned in contact with the transparent electrode layer 140. For example, in a N-I-P structure, the first surface 152 of the ETL 150 can be provided upon the second surface 144 of the transparent electrode layer 140. The ETL 150 may have any suitable thickness between the first surface 152 and the second surface 154, including, for example, more than about 2 nm in one embodiment, between 2 nm and 100 nm, between 10 nm and 80 nm in another embodiment, or between 15 nm and 60 nm in a further embodiment. The ETL can include one or more layers of suitable material, including, but not limited to, PCBM (phenyl-C61-butyric acid methyl ester), C60, BCP (bathocuproine), lithium fluoride (LiF), or metal oxides, such as TiO₂, ZnO, SnOₓ ZnSnO₄, or SrTiO₃.

The photovoltaic device 100, 200 can include an absorber layer 160 comprising a perovskite material configured to cooperate with adjacent layers to form a N-I-P or P-I-N junction within the photovoltaic device. Accordingly, absorbed photons of light can free electron-hole pairs and generate carrier flow, which can yield electrical power.

Lead halide and other metal halide perovskite compounds may be used in an absorber layer of a photovoltaic device. The metal halide perovskite compounds have an ABX₃ structure, where A and B are cations and X is a halogen anion. In examples, the A site may be occupied by one or more organic or inorganic cations. For example, the A site may be composed of one or more of: methylammonium (MA), formamidinium (FA), cesium (Cs), or rubidium (Rb) cations. The B site may be occupied by one or more metals, such as lead (Pb) or tin (Sb). And the X site may be occupied by one or more halogen, such as iodine (I), bromine (Br), fluorine (F), or chlorine (Cl). In a photovoltaic device, an absorber layer of perovskite material may be positioned in contact with and between a negative charge transport layer and positive charge transport layer.

The perovskite absorber layer may be formed by selecting and reacting one or more A-type cations or A-X-type compounds with one or more B-X compounds. Metal halide materials suitable for use as a B-X compound in forming a perovskite compound for an absorber layer include iodides, bromides, and/or chlorides, in combination with a metal, alkali metal and/or combinations thereof. In some embodiments, the B-X material is a group 14 metal salt. Metal halide or B-X materials suitable for use in a perovskite compound include, but are not limited to, lead iodide (PbI₂), cesium iodide (CsI), lead bromide (PbBr₂), cesium bromide (CsBr), cesium lead iodide (CsPbI₃), cesium tin iodide (CsSnI₃), lead chloride (PbCl₂), tin iodide (SnI₂), tin bromide (SnBr₂), and/or tin chloride (SnCl₂).

The absorber layer 160 can have a first surface 162 substantially facing the energy side 102 of the photovoltaic device 100, 200 and a second surface 164 substantially facing the opposing side 104 of the photovoltaic device. A thickness of the absorber layer 160 can be defined between the first surface 162 and the second surface 164.

In an example device, the thickness of the absorber layer 160 can be between about 150 nm to 10000 nm, such as, for example, between 200 nm to 6000 nm in an embodiment, between 300 nm to 3000 nm in an embodiment, between 400 nm to 2000 nm in an embodiment, between 400 nm to 1500 nm in an embodiment, or between 1500 nm to 4000 nm in another embodiment.

The photovoltaic device 100, 200 can include a hole transport layer (HTL). The hole transport layer (HTL) 180 may also be called a positive charge transport layer, p-type transport layer, hole transport material, h⁺ selective contact, or a hole-selective layer. It may be positioned in contact with a conducting layer which functions as a cathode. The HTL 180 provides electrical contact to the absorber layer 160. The HTL 180 can have a first surface 182 substantially facing the front side 102 of the photovoltaic device 100, 200 and a second surface 184 substantially facing the opposing side 104 of the photovoltaic device. A thickness of the HTL 180 can be defined between the first surface 182 and the second surface 184. The thickness of the HTL 180 can be between about 2 nm to about 400 nm, such as, for example, between 2 nm to 200 nm in an embodiment, between 2 nm to 100 nm in an embodiment, or between 2 nm to 50 nm in an embodiment. In an N-I-P structure, the HTL 180 may be provided adjacent to the absorber layer 160 on the back side, such that the first surface 182 of the HTL 180 is provided upon the second surface 164 of the absorber layer 160. In an P-I-N structure, the HTL 180 may contact the absorber layer 160 on the front or light-facing side, such that the second surface 184 of the HTL 180 is adjacent the first surface 162 of the absorber layer 160. In embodiments described, the HTL 180 comprises at least two sublayers.

The photovoltaic device 100, 200 can include a p-type contact, cathode, or conducting layer 190. The conducting layer 190 can have a first surface 192 substantially facing the energy side 102 of the photovoltaic device and a second surface 194 substantially facing the opposing side 104 of the photovoltaic device.

In embodiments having a N-I-P structure, as shown in FIG. 1, the conducting layer 190 may function as a back electrode and be provided adjacent to the HTL 180 such that the first surface 192 of the conducting layer 190 contacts the second surface 184 of the HTL 180.

In embodiments having a P-I-N structure, as shown in FIG. 2, the conducting layer 190 is provided between the substrate 110 and absorber 160, and may be adjacent to the HTL 180 such that the second surface 194 of the conducting layer 190 contacts the first surface 182 of the HTL 180. In devices with a P-I-N structure, both the HTL 180 and the conducting layer 190 are substantially transparent.

In some embodiments, the conducting layer 190 can comprise a conducting material such as, for example, one or more layers of a composition such as a metal, a metal oxide, or nitrogen-containing metal, silver, nickel, copper, aluminum, titanium, palladium, chrome, molybdenum, gold, or the like. Examples of a nitrogen-containing metal layer can include aluminum nitride, molybdenum nitride, nickel nitride, titanium nitride, tungsten nitride, selenium nitride, tantalum nitride, or vanadium nitride. An example metal oxide conducting material includes tin oxide. In some embodiments, the conducting layer 190 is transparent and may comprise a transparent conductive oxide (TCO), a wide bandgap nitride, or other wide bandgap semiconductor. In alternate embodiments, the conducting layer 190 may be substantially transparent and layer 110 may be substantially opaque. In some embodiments, the conducting layer 190 may be indium tin oxide, fluorine-doped tin oxide, or aluminum tin oxide.

The photovoltaic device 100, 200 can include a back support 196 configured to cooperate with the substrate 110 to form a housing for the one or more photovoltaic cells. The back support 196 can be disposed at the opposing side 104 of the photovoltaic device. As an example, in a N-I-P structure, as shown in FIG. 1, the back support 196 can be formed adjacent to the back contact conducting layer 190. As an example, in a P-I-N structure, as shown in FIG. 2, the back support 196 may be formed adjacent to the electrode layer 140. The back support 196 can include any suitable material, including, for example, glass (e.g., soda-lime glass). In some embodiments the back support 196 can be another solar cell in electrical contact to layer 190 to form a tandem or multijunction device. In some embodiments the substrate 110 can be another solar cell in electrical contact to layer 130 to form a tandem or multijunction device. In some embodiments, an encapsulation layer can also function as the back support 196.

The photovoltaic device 100, 200 can optionally include one or more interlayers and/or one or more buffer layers. A buffer layer can be configured to provide an insulating layer between adjacent layers. The buffer layer may include material having higher resistivity than an adjacent layer, and may include, but is not limited to, intrinsic tin dioxide, zinc magnesium oxide (e.g., Zn₁₋ₓMgₓO), silicon dioxide (SiO₂), aluminum oxide (Al₂O₃), aluminum nitride (AlN), zinc tin oxide, zinc oxide, tin silicon oxide, or combinations thereof. In some embodiments, the material of the buffer layer can be configured to substantially match the band gap of an adjacent semiconductor layer. The selection of buffer layer thickness may depend on the type of buffer material and its level of resistivity. The buffer layer may have a thickness, including, for example, more than about 10 nm in one embodiment, between 2 nm and 80 nm in another embodiment, or between 15 nm and 60 nm in a further embodiment.

Charge transport in a P-I-N structure is reversed relative to a N-I-P structure; in a P-IN device, a positive charge transport layer is proximate to the light-facing front side relative to a negative charge transport layer.

In some embodiments, selected layers, including a HTL, a perovskite absorber, and an ETL, are included in a tandem device. In methods for forming a tandem device, the methods for forming the perovskite layer may include forming the perovskite layer over a contact layer of a substrate stack wherein the substrate stack comprises a cell stack and a tunnel junction.

A partly-formed N-I-P structured device, including a substrate 110, an ETL 150, and layers therebetween, may be referred to as a substrate stack 113.

A partly-formed P-I-N structured device, including a substrate 110, a HTL 180, and layers therebetween, may be referred to as a substrate stack 213.

The layer of the partly-formed substrate stack 113, 213 opposite the substrate may be referred to as a first contact layer. The first contact layer of the substrate stack is equivalent to the ETL 150 for a device with N-I-P orientation, or the HTL 180 in a device with P-I-N orientation. As used herein, the intermediate structure of the partly-formed substrate stack or 113, 213 does not include an absorber layer. In a fully-formed device, an absorber layer is disposed between the first contact layer and a second contact layer, the second contact layer having a charge opposite to the first contact layer. The second contact layer is equivalent to the HTL 180 for a device with N-I-P orientation, or the ETL 150 in a device with P-I-N orientation. Optionally, the substrate stack may further include one or more additional layers, such as a buffer layer, a high resistance layer, or an antireflective layer.

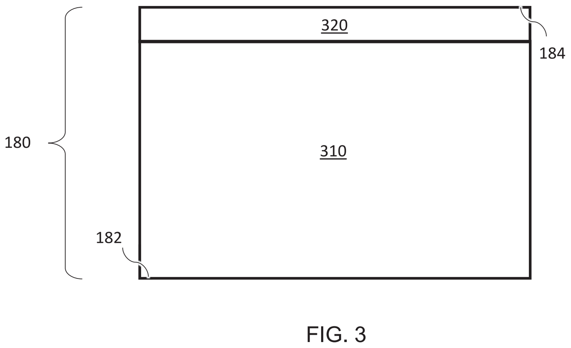

FIGS. 3-4 depict example hole transport layers having two sublayers. The first sublayer 310 of the HTL 180 is proximate to the conducting layer 190. The second sublayer 320 is proximate to the perovskite absorber layer 160. In the embodiment depicted in FIGS. 3-4 the first sublayer 310 is adjacent to the second sublayer 320.

FIG. 3, depicts an example embodiment HTL for a P-I-N device, with a first sublayer 310 overlaid by a second sublayer 320. In the example embodiment shown, the first sublayer 310 is contiguous with and defines the first surface 182 of the hole transport layer HTL 180, positioned over and adjacent to the front contact conducting layer 190. In the example embodiment shown, the second sublayer 320 of the HTL 180 is positioned over and adjacent to the first sublayer 310 and is contiguous with and defines the second surface 184 of the HTL 180.

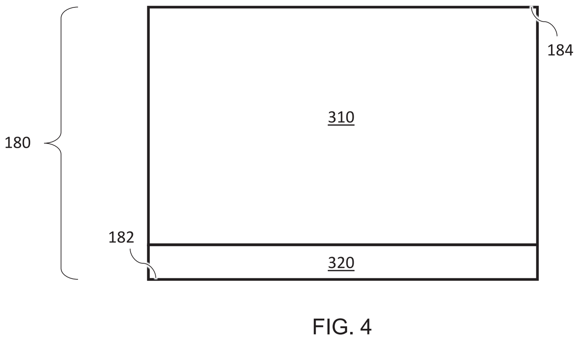

FIG. 4, depicts an example embodiment HTL for a N-I-P device, with a second sublayer 320 over the absorber and a first sublayer 310 over the second sublayer 320. In the example embodiment shown, the first sublayer 310 is contiguous with and defines the second surface 184 of the hole transport layer HTL 180, positioned under and adjacent to the back contact conducting layer 190. In the example embodiment shown, the second sublayer 320 of the HTL 180 is over the absorber layer 160, and the first sublayer 310 is positioned over and adjacent to the second sublayer 320. The first sublayer 310 and is contiguous with and defines the second surface 184 of the HTL 180.

In some embodiments, the first sublayer 310 has a thickness in a range of 0.1 nm to 150 nm. In some embodiments, the first sublayer 310 has a thickness in a range of 0.5 nm to 100 nm, 1.0 nm to 100 nm, 4.0 nm to 100 nm, 0.5 nm to 50 nm, 1.5 nm to 50 nm, 2.0 nm to 50 nm, 4.0 nm to 50 nm, 0.5 nm to 25 nm, 1.5 nm to 25 nm, 2.0 nm to 25 nm, 4.0 nm to 25 nm, or 2 nm to 20 nm.

In some embodiments, the second sublayer 320 has a thickness in a range of 3 angstroms to 100 angstroms (0.3 nm to 10 nm). In some embodiments, the second sublayer 320 has a thickness in a range of 5-100 Å, 5-80 Å, 5-50 Å, 5-30 Å, 5-20 Å, 10-100 Å, 10-80 Å, 10-50 Å, 10-30 Å, or 10-20 Å.

In some embodiments, the first sublayer 310 is thicker than the second sublayer 320. In some embodiments, the first sublayer 310 has a thickness at least two times greater than the second sublayer 320 thickness. In some embodiments, the first sublayer 310 is two to ten times thicker than the second sublayer 320. In some embodiments, the first sublayer 310 is at least four times thicker than the second sublayer 320. In some embodiments, the first sublayer 310 is four to ten times thicker than the second sublayer 320. In some embodiments, the total thickness of the HTL 180, including both the first layer 310 and the second layer 320, has a total thickness in a range of 1 nm to 200 nm, 1 nm to 100 nm, 5 nm to 50 nm, 10 nm to 100 nm, 10 nm to 50 nm, 4 nm to 30 nm, 4 nm to 25 nm, or 5 nm to 25 nm.

In some embodiments, the first sublayer comprises an inorganic hole transport material and the second sublayer comprises an organic hole transport material.

In some embodiments, the first sublayer comprises a wide band gap inorganic compound. In some embodiments, a band gap of the material comprising the first sublayer is greater than 3.0 eV, greater than 3.4 eV, or in a range of 3.1 to 4.9 eV. In other embodiments, a material with a lower band gap may be used in a thinner first sublayer. In some embodiments the first sublayer is an inorganic material having a band gap less than 3.0 eV, less than 2.2 eV, or in a range from 1.6 eV to 3.0 eV, with a first sublayer thickness of less than 50 nm. In some embodiments having a band gap less than 2.2 eV, the first sublayer thickness is less than 25 nm.

In some embodiments, the second sublayer comprises an organic compound. In some embodiments, a band gap of the material comprising the second sublayer is greater than 1.8 eV, greater than 2.3 eV, or in a range of 1.6 to 4.9 eV. In some embodiments, a band gap of the material comprising the first sublayer is greater than a band gap of the material comprising the second sublayer.

In some embodiments, the first sublayer comprises an organometallic material or an inorganic hole transport material. In some embodiments, the first sublayer comprises a metal oxide, a metal nitride, or a metal oxynitride. In some embodiments, the first HTL sublayer comprises a metal oxide. In some embodiments, a hole transport material for the first sublayer may include one or more of: nickel oxide (NiOₓ), copper thiocyanate (CuSCN), copper phthalocyanine (CuPc or C₃₂H₁₆CuN₈), tungsten oxide (WO₃), copper iodide (CuI), or copper oxide (CuOₓ). In some embodiments, the first HTL sublayer comprises copper indium sulfide, copper chromium iodide, molybdenum oxide, vanadium oxide, aluminum oxide, zinc telluride, cobalt zinc oxide, graphene oxide, and/or tungsten oxide. In some embodiments the first HTL sublayer comprises a carbazole based self-assembled monolayer such as 2PACz, MeO-2PACz, or Me-4PACz. In some embodiments, a hole transport material for the first sublayer may include an oxynitride compound comprising at least one of molybdenum (Mo), silicon (Si), zirconium (Zr), tungsten (W), or halfnium (Hf). In some embodiments, a hole transport material for the first sublayer may include a nitride compound comprising at least one of aluminum nitride, molybdenum nitride, nickel nitride, titanium nitride, tungsten nitride, selenium nitride, tantalum nitride, or vanadium nitride. In some embodiments, a hole transport material for the first sublayer is doped with one or more elements selected from Cu, Li, K, Cs, Mg, Ca, Sr, Ba Eu, Tb, or Er. In some embodiments, the first sublayer comprises NiO, CuSCN, CuPc, or CuI. In some embodiments, the first sublayer consists essentially of NiOₓ.

In some embodiments, the second sublayer comprises an organic hole transport material. In some embodiments, the second sublayer comprises a polymer or a small molecule. In some embodiments, the second sublayer comprises at least one hole transport material selected from: PTAA (poly-triarylamine or Poly[bis(4-phenyl)(2,4,6-trimethylphenyl)amine]), P3HT (Poly(3-hexylthiophene-2,5-diyl)), P3HT-COOH (poly[3 - (6 - carboxyhexyl)thiophene - 2,5 - diyl]), poly-TPD (4-butyl-N,N-diphenylaniline homopolymer), PEDOT:PSS (Poly(3,4-ethylenedioxythiophene)-poly(styrenesulfonate)), Spiro-OMeTAD (N2,N2,N2',N2',N7,N7, N7',N7'-octakis(4-methoxyphenyl)-9,9'-spirobi[9H-fluorene]-2,2',7,7'-tetramine), SAF-OMe (N2,N2,N2',N2', N7,N7,N7',N7'-octakis(4-methoxyphenyl)-10-phenyl-10H-spiro[acridine-9,9'-fluorene]-2,2', 7,7'-tetraamine), OMeTPA-FA, SGT-407, Fused-F, TTF-1 (tetrathiafulvalene), alpha-NPD, TIPS-pentacene (6,13-bis(triisopropyl-silylethynyl)pentacene), PCPDTBT, PCDTBT, or quinolizino acridine. Other suitable organic HTMs may include small molecules that include at least one of a pyrene, thiophene, porphyrin, and/or carbazole; e.g. 1-(N,N-di-p-methoxyphenylamine) pyrene, 4,4'-cyclohexylidenebis[N,N-bis(4-methyl phenyl) benzenamine], 2,5-bis(4,4'-bis(methoxyphenyl) aminophen-4"-yl)-3,4-ethylene dioxythiophene, 2,3,4,5-tetra [4,4'-bis(methoxyphenyl) aminophen-4"-yl]-thiophene, 4,4',5,5'-tetra [4,4'-bis(methoxyphenyl) aminophen-4"-yl] -2,2'-bithiophene, 5,10,15,20-tetrakis (4-bromophenyl) porphyrin, 5,10,15,20-tetrakis (5-bromopyridine-2-yl) porphyrin, 5,10,15,20-tetrakis (4-bromophenyl) porphyrin zinc(II), 5,10,15,20-tetrakis(5-bromopyridine-2-yl) porphyrin zinc(II), and/or 1,3,6,8-tetra (N, N-p-dimethoxyphenylamino)-9-ethylcarbazole, graphene oxide, copper pthalocyanine, 2,2',7,7'-Tetra(N,N-di-p-tolyl)amino-9,9-spirobifluorene (spiro-TTB), carbon nanotubes, or EH44 ((9-(2-ethylhexyl)-N,N,N,N-tetrakis(4-methoxyphenyl)-9H-carbazole-2,7-diamine)). In some embodiments the second sublayer of the hole transport layer comprises polyelectrolyte (P3CT-N, P3CT-Rb), spiro[fluorene-9,9 ' -xanthene] (SFX)-based 3D oligomers (X55). In some embodiments the second sublayer comprises a carbazole based self-assembled monolayer such as 2PACz, MeO-2PACz, or Me-4PACz.

In an example process flow for forming a photovoltaic device, a substrate stack is prepared. The substrate may be formed of a transparent support, such as glass, with a transparent conducting layer over the substrate. A first contact layer is disposed over the conducting layer and the transparent support to form a substrate stack. Optionally, the substrate stack may further include a first scribe set, and one or more additional layers, such as a buffer layer, a high resistance layer, or an antireflective layer. The substrate stack may be cleaned. The substrate stack may be cleaned with a fluid, such as a solvent or a gas, or UV ozone, or oxygen plasma. An intermediate structure for a perovskite photovoltaic device may be formed by depositing one or more perovskite precursor materials on the substrate stack. An absorber layer comprising a perovskite layer is formed on the substrate stack. A second contact layer, having opposite polarity to the first contact layer, is formed over the absorber layer, and an electrode layer is formed over the second contact layer to produce a layer stack.

A substrate stack, an intermediate structure for a perovskite photovoltaic device, and/or a layer stack may be annealed. An annealing process may include controlling temperature, atmosphere, humidity, pressure, gas concentration and partial pressure, vapor concentration, reactant concentration, reactant exposure time, and heating duration. In some embodiments, one or more dopants may be incorporated during the annealing process. The perovskite layer may be passivated during formation or annealing of the perovskite absorber layer, for example by exposure to compounds containing a halide. The perovskite absorber layer may optionally be passivated after formation or annealing. A diffusion barrier or moisture barrier layer may be added. The substrate stack and layer stack may be scribed, for example by a laser. An encapsulation layer may be applied over the completed device layer stack. Bussing or other electrical connections and a back support may be added to the layer stack.

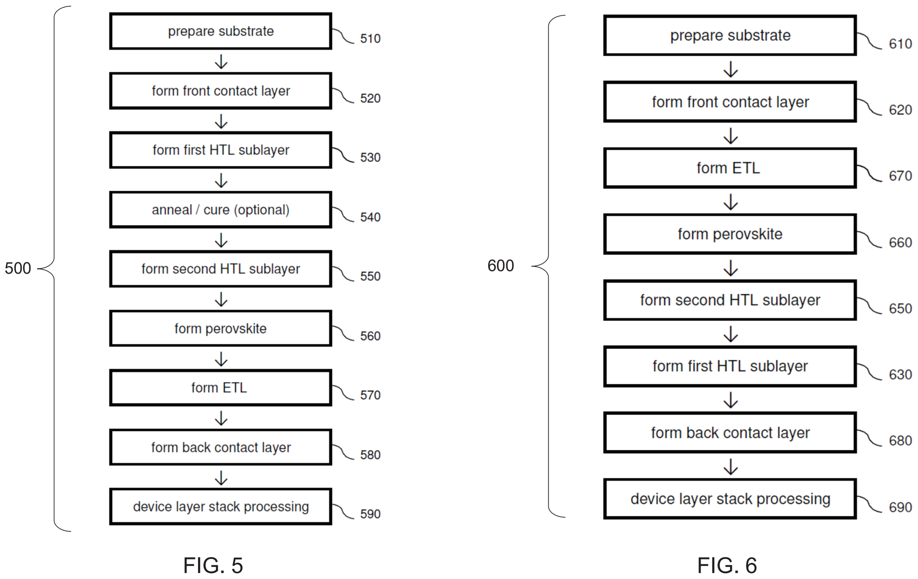

Turning now to FIG. 5, an overview of an example process flow of a method 500 for forming a P-I-N photovoltaic device is described.

After the substrate is prepared 510, a transparent front contact layer is formed 520 which functions as an electrode. The first HTL sublayer is formed 530 on the front contact layer. Optionally, the partly-formed device including the first HTL sublayer may be treated 540, such as by heating, curing, or annealing. The second HTL sublayer is formed 550 over the first HTL sublayer. The perovskite absorber layer is formed 560 over the second HTL sublayer.

The absorber layer may be formed in one of several ways, such as by a one-step or two-step deposition process. In a one-step deposition, a metal halide and a cation precursor are deposited simultaneously and react while heat is applied to form the perovskite absorber layer. In a two-step deposition, a metal halide layer is formed and a cation layer is deposited over the metal halide layer to form an intermediate structure for a perovskite photovoltaic device. In an example method, one or more B-X materials, for example, lead iodide (PbI₂), is deposited in a contiguous B-X layer on the substrate stack. One or more A-type cations or A-X materials, for example, formamidinium iodide (FAI), is deposited over the B-X layer. The intermediate structure of the substrate stack with the B-X layer and A-type cation are subjected to heat treatment to react the metal halide and cation layers to form the perovskite absorber layer, for example a FAPbI₃ perovskite material. Formation of the metal halide layer may optionally include administration of gentle heating prior to deposition of the cation layer. The intermediate structure of the substrate stack with the metal halide layer and cation layer may be subjected to heat treatment to react the metal halide and cation layers to form the perovskite absorber layer. During heat treatment, controlled parameters may include: temperature, pressure, ambient gases, humidity, and treatment duration.

High sustained temperatures, for example, over about 200° C for 1-2 minutes, are likely to damage the perovskite material. To maintain absorber layer integrity, processing steps following the formation of the perovskite absorber are selected to not expose the intermediate structure, with the perovskite absorber layer, to high temperatures or other conditions that could cause damage. Both the perovskite material and, also, often an organic HTL material, such as many materials suitable for the second sublayer of the HTL, are susceptible to damage from heat, moisture, etchants, and some solvents.

After the perovskite layer is formed 560, a second contact layer is formed 570 to produce an ETL over the perovskite layer, and an electrode layer is formed 580 over the second contact layer to complete the device layer stack. The device layer stack may be further processed 590 to complete the photovoltaic device, for example by annealing, scribing, applying bussing and electrical connectors, applying encapsulant seals or coatings, and other steps to facilitate use of the photovoltaic device.

FIG. 6 shows an overview of an example process flow of a method 600 for forming a N-I-P photovoltaic device.

The substrate is prepared 610, and a transparent front contact layer is formed 620 over the substrate and functions as an anode. An electron transport layer (ETL) is formed 670 over the front contact layer. The perovskite absorber layer is formed 660 over the ETL and may be formed in stages, such as by a one-step or two-step deposition process. The second HTL sublayer is formed 650 over the perovskite absorber layer, and the first HTL sublayer is formed 630 over the second HTL sublayer. A back contact layer is formed 680 over the first HTL sublayer to complete the device layer stack. The device layer stack may be further processed 690 to complete the photovoltaic device.

The first HTL sublayer and the second HTL sublayer have different compositions. In embodiments, the first HTL sublayer is thicker than the second sublayer. In the methods, the first HTL sublayer is formed between the contact layer and the second HTL sublayer. The second HTL sublayer is formed between the first HTL sublayer and the absorber layer. In embodiments, an HTL material of the first HTL sublayer has a higher band gap than an HTL material of the second HTL sublayer. In some embodiments, the first HTL sublayer may comprise, for example, an inorganic hole transport material or an organometallic material. In some embodiments, the second HTL sublayer may comprise an organic hole transport material, such as, for example, PTAA, undoped Spiro-OMeTAD, P3HT, or P3HT-COOH.

In methods for forming a P-I-N device, as in FIG. 5, higher temperature deposition and annealing methods may be used in forming the first HTL sublayer. Inorganic hole transport materials, such as NiOx, WO₃, CuI, and CuOₓ are thermally stable at higher temperatures and mechanically robust, thereby accommodating a broad range of processing methods. For example a partially formed device with a glass substrate, an fluorine-doped tin oxide (FTO) front contact, and a first HTL sublayer comprising NiOₓ may be annealed at a temperature in a range of 200° C to 500° C, for example at about 300° C. In embodiments of the method, the HTL layer is formed by sequential deposition of two sublayers.

In methods for forming an N-I-P device, as in FIG. 6, low or moderate temperatures may be selected for forming the first HTL sublayer to reduce the risk of damage to temperature-sensitive underlying layers, such as the perovskite absorber layer or the second HTL sublayer. The low or moderate temperatures selected may be below 200° C, or below 160° C. For example, a partially formed device with a structure of glass / TCO / ETL / perovskite / PTAA / NiOₓ may be subjected to a thermal treatment at a temperature in a range of 90° C to 160° C. In another example, a NiOx film may be deposited by vacuum or solution-based methods over the second HTL sublayer and, optionally, may be treated by vacuum annealing at about 100° C.

Perovskite solar cell efficiency relies on the hole transport layer and electron transport layer for separation of electrons and holes for efficient charge conduction. The material properties and optoelectronic characteristics desired for high performance devices include, but are not limited to: high hole mobility and conductivity, good energy alignment with adjacent layers, formation of a good interface with the selected perovskite absorber, and robust chemical and thermal stability. In addition, film qualities such as good adhesion, cohesion, continuity and conformality are also important for device performance. However, these qualities may not be completely attainable from a single hole transport material.

For example, Spiro-OMeTAD has been shown to be an excellent hole contact for perovskite devices to achieve high efficiency. However, because of its low glass transition temperature when mobile dopants are used and the need for using mobile ions as dopants for high hole mobility, it is generally considered as not suitable for long-term stable devices. Many polymeric HTL materials may form a self-passivated interface with perovskite layer, but they are usually less conductive and more mechanically fragile than inorganic materials. PTAA has been shown as one of best HTL materials for perovskite devices. It appears to have good energy alignment with perovskite and high efficiency; however it is a very expensive material and tends to be mechanically fragile. P3HT also appears to be an efficient hole transfer material, but, it has a low band gap (~2 eV) and may absorb light before the light reaches the absorber. For these HTL materials, an ultra-thin layer (e.g. from a few angstroms to a few nanometers) may be used to accommodate relatively high resistivity, unless those HTL materials are doped with other more conductive ingredients. However, dopants for HTL materials can lead to instability issues.

Inorganic and organometallic hole transport materials, such as NiOx, CuSCN, and CuPc have thermal stability and are more robust mechanically. However, development of high-efficiency perovskite devices has been inconsistent, and results showing high-performance have been difficult to replicate. While inorganic and organometallic hole transport materials are typically more stable, they may not form a good interface with a perovskite layer. For example, NiOx may produce devices with low Voc and can exhibit unpredictable energy alignment due, in part, to difficulty in controlling its oxidation state consistently. Additionally, the interface between NiOx and a perovskite layer is prone to form microstructural and electronic defects.

Methods and devices using a bilayer HTL, with differing materials as HTL sublayers, have now been developed to address the deficiencies of existing hole transport layers. The methods and compound HTL structures have measureable, interrelated, and reinforcing benefits. Without wishing to be bound by theory, it is believed that the described sublayer combinations confer beneficial aspects of the individual materials comprising the sublayers, while mitigating detrimental aspects of each material. The performance of a single HTL material can be improved by adding a second layer of another HTL material. The improvement can be in the form of performance enhancement, interfacial mismatch mitigation, and stability with respect to: moisture, oxygen, thermal stresses, photo (UV) degradation, and mechanical degradation, including fracture or delamination. Furthermore, the dual HTL can alleviate the problem of interfacial defects between the HTL and perovskite absorber layer which can act as trap states and cause carrier recombination.

Using bilayer hole transport materials in suitable pairings, the sublayer combination can leverage strengths and minimize the weaknesses of an individual HTM. The two hole transport materials can be so chosen as to tune the desirable performance of the device. For example the two materials can act a better bridge between a selected front contact material, such as, for example, indium tin oxide (ITO), and a perovskite absorber layer, such as MAPbI₃, for a P-I-N structure or between the perovskite absorber and a back metal contact for an N-I-P structure.

More specifically, a bilayer HTL coating may include a thin layer of a HTM, for directly interfacing with the perovskite absorber - the second HTL sublayer, and a relatively thicker layer of another HTM - the first HTL sublayer, which accounts for the bulk of the hole transport layer. The thin HTM sublayer may include organic materials, such as, P3HT, P3HT-COOH, PTAA, un-doped Spiro-OMeTAD, Spiro-TTB, and Poly-TPD. The thicker HTM sublayer may include inorganic or organometallic compounds such as NiOx, CuSCN, and CuPc.

Using the NiOx/PTAA bilayer approach, cell efficiencies of approximately 18-21% were demonstrated, and observed Voc values in the experimental P-I-N devices met or exceeded record high Voc values for NiOx based P-I-N devices.

A bilayer HTL for P-I-N structures may include selected sublayer combinations coated on TCO substrates. As a non-limiting example, the combinations can include a nickel oxide first HTL sublayer and an organic material second HTL sublayer, such as, for example: NiOx/PTAA; NiOx/P3HT; NiOx/undoped Spiro; or NiOx/Poly-TPD. An example NiOx sublayer may be formed with NiOx sol gel or other Ni precursor solutions and annealing; for a P-I-N structure, this process facilitates curing the NiOx precursor at a higher temperature. NiOx layers can be prepared by various processes, including, for example, reactive sputtering, pulsed laser deposition, sol-gel, sono-chemical methods, nanoparticles, spray pyrolysis, nanoparticle spin-on, or spray combustion. A NiOx precursor can be doped with other metals such as Cu, Li, K, Cs, Mg, Ca, Sr, Ba Eu, Tb, Er to tune for desired properties. In example P-I-N structures, the NiOx sublayer may be replaced with CuPc or CuSCN. CuPc coating as the first HTL sublayer can be formed, for example, by an evaporation process. CuSCN coating the first HTL sublayer can be formed, for example, by a wet-solution chemistry process. For a P-I-N structure, the second HTL sublayer may be formed over the first HTL sublayer. The second HTL sublayer may be deposited, by coating with a second HTL material, such as PTAA, P3HT, P3HT-COOH, or undoped Spiro-OMeTAD, on top of the first HTL sublayer (e.g. NiOx). Use of undoped Spiro-OMeTAD, rather than doped Spiro-OMeTAD, avoids instability problems and use of hygroscopic dopants. The second HTL sublayer may be formed, for example, with wet-solution chemistry processes. Completion of the device structure may then include forming a perovskite layer, forming another contact layer, and forming a back contact.

A bilayer HTL for N-I-P structures may include selected sublayer combinations coated over a partly-formed layer stack including a substrate, a front contact, an ETL, and an absorber. For N-I-P structures, a second HTL sublayer may be deposited, by thinly coating a second HTL material, such as PTAA, P3HT, P3HT-COOH, or undoped Spiro-OMeTAD, on top of the absorber layer. A first HTL material, such as NiOx, CuSCN, or CuPc, may then be deposited over the second HTL material. Deposition techniques for forming and treating the first HTL sublayer, such as those selected for NiOx, may utilize milder techniques having a low thermal budget, such as, for example, nanoparticle coating. The formation of a bilayer HTL for N-I-P structures involves coating of HTL materials over a perovskite layer, thus, low temperatures (under 200° C, or under 160° C) may be preferred. The second hole transport materials for the N-I-P structure can be coated at a suitable lower temperature to protect the perovskite layer.

In an example process, control and experimental devices were prepared for P-I-N structured devices. The control devices had a NiOx HTL deposited by sputter coating to a thickness of 3 nm or 4 nm, at 4% O₂. The experimental devices had a NiOx first HTL sublayer deposited by sputter coating to a thickness of 3 nm or 4 nm, at 4% O₂, and a PTAA second HTL sublayer spin coated over the NiOx layer. The PTAA layer was formed with PTAA concentration at 0.5 mg/mL, 1.0 mg/mL, or 2 mg/mL, with a coating speed of 4000 rpm or 5000 rpm. A further set of devices were prepared with two layers of NiOx, the first NiOx layer sputter coated as described for the controls, and the second NiOx layer formed by a NiO sol gel over the sputtered NiOx layer.

Substrates with a transparent conductive oxide (TCO) coating were cleaned by cleaning procedures such as detergent wash, deionized water wash, or oxygen plasma cleaning. The HTL was formed for experimental devices and controls, as described above. A perovskite absorber layer was formed using a two-stage process including: deposition of a PbI₂ layer, followed by coating the PbI₂ layer with a solution including FAI, MAI, and MACl in an alcohol solvent, followed by heat treatment at about 100° C to 150° C for about 10 to 20 minutes. A PCBM/BCP ETL layer was then formed over the perovskite absorber layer by spin coating and curing at about 75° to 100° C, and a silver (Ag) back contact was applied over the ETL.

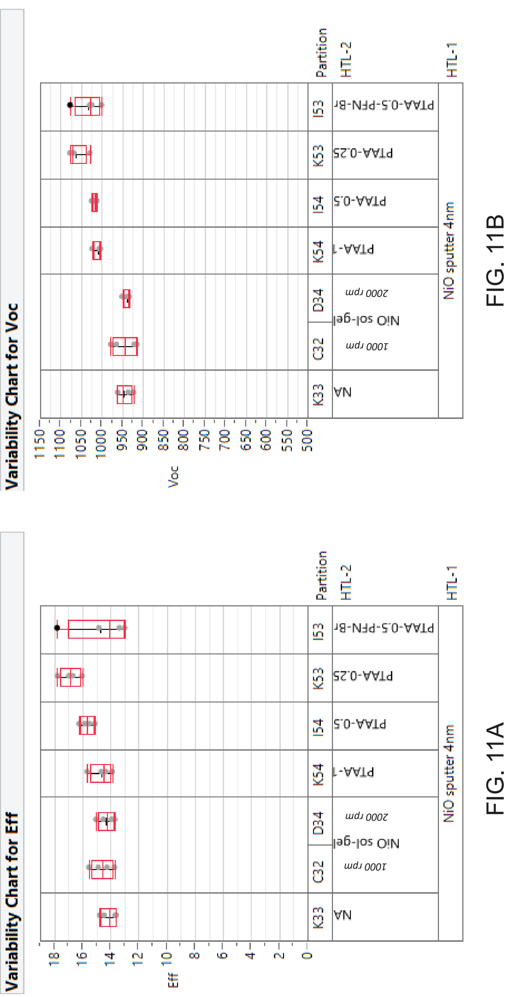

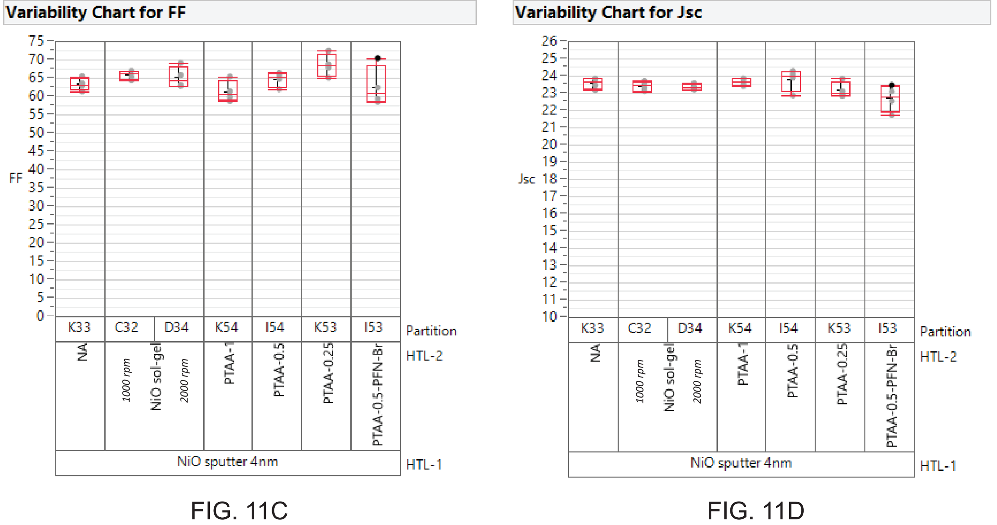

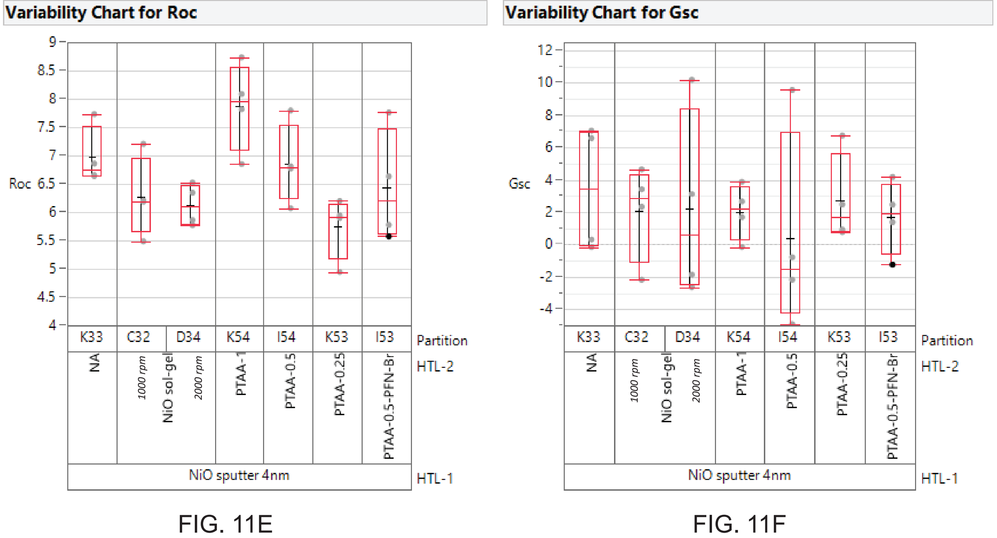

FIGS. 11A-11F show device performance characteristics for experimental structures, with a bilayer HTL of NiOx and PTAA, and controls, with a NiOx HTL, formed by the methods, as described above. The performance data includes measurements of efficiency, open-circuit voltage (Voc), fill factor (FF), short-circuit current density (Jsc), open circuit resistance (Roc), and short-circuit conductance (Gsc). Without wishing to be bound by theory, it is believed that the bilayer of the NiOx sublayer with a thin PTAA sublayer may enhance the device structure by surface defect passivation of the TCO, lower interface recombination, and the polymer may planarize the rough surface. Additionaly the sublayer structure promotes good interfacial alignment, and promotes even formation of the perovskite layer by the greater hydrophobicity of PTAA relative to NiOx. Resulting devices formed by PTAA spin coated on top of sputtered NiO had good device efficiency, with PCE 17.8%, FF 72% and Voc > 1V.

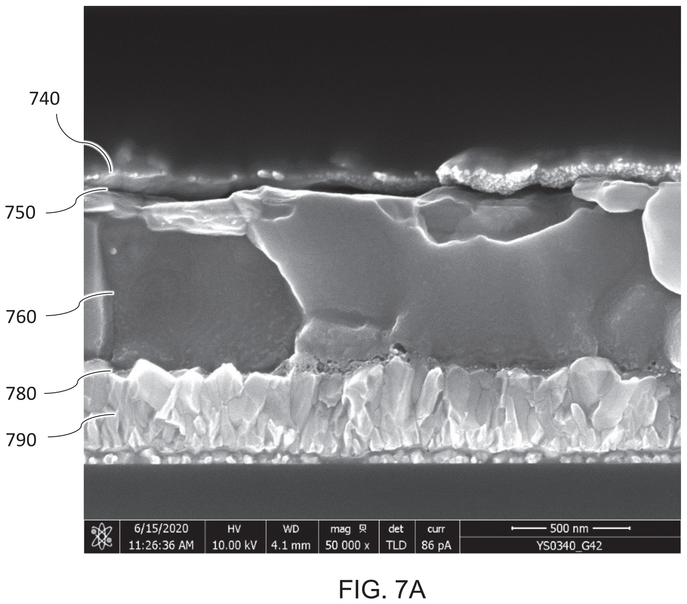

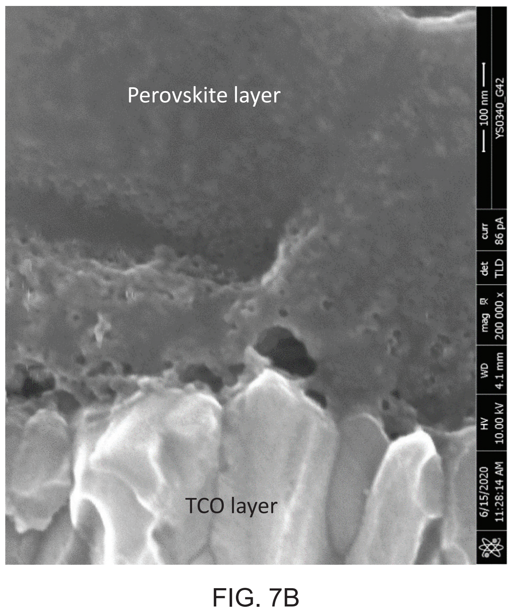

FIGS. 7A and 7B show a cross-section SEM of a segment of a P-I-N structured device with only a NiOx layer as HTL. FIG. 7A shows a fluorine-doped tin oxide front contact TCO layer 790, overlaid by a thin NiOx HTL 780 that is nearly imperceptible at the magnification shown. A perovskite absorber layer 760 is over the HTL 780, and the layer stack includes an ETL with an Ag back contact. FIG. 7B provides a higher magnification of the absorber layer at the front interface with the HTL. The perovskite absorber exhibits irregularities and defects at the front interface, appearing bubbled or porous.

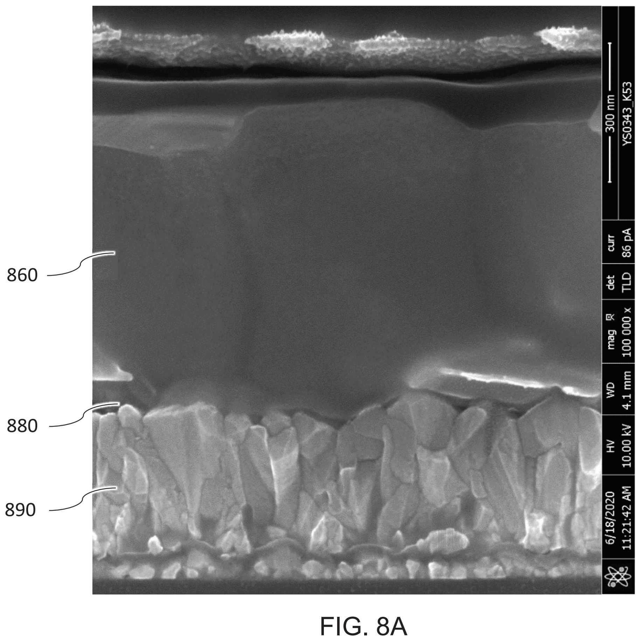

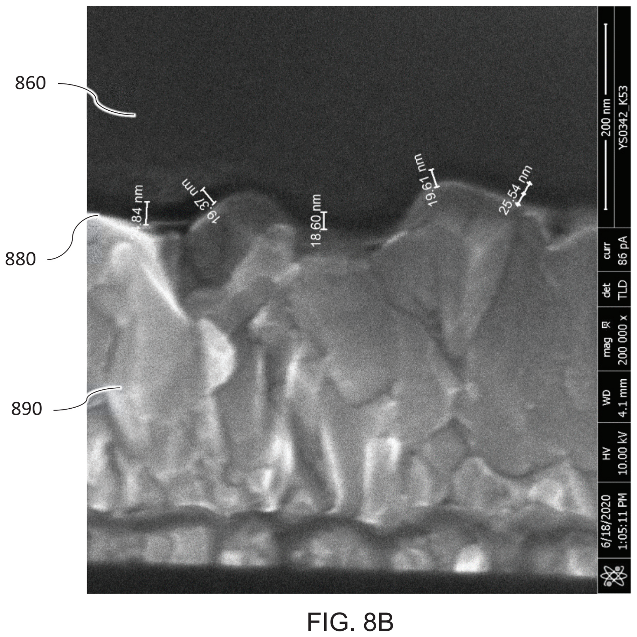

FIGS. 8A and 8B show a cross-section SEM of a segment of a P-I-N structured device with a bilayer HTL, including a NiOx first sublayer and a PTAA second sublayer, with the perovskite absorber layer formed over the second sublayer. The HTL bilayer 880 is formed over a fluorine-doped tin oxide front contact TCO layer 890. The perovskite absorber layer 860 is formed over the PTAA second sublayer of the bilayer HTL 880. The front interface of the perovskite absorber is substantially defect free, without porousness. FIG. 8B shows thickness measurements of the HTL with total thickness of 24.84 nm, 19.37 nm, 18.60 nm, and 25.54 nm.

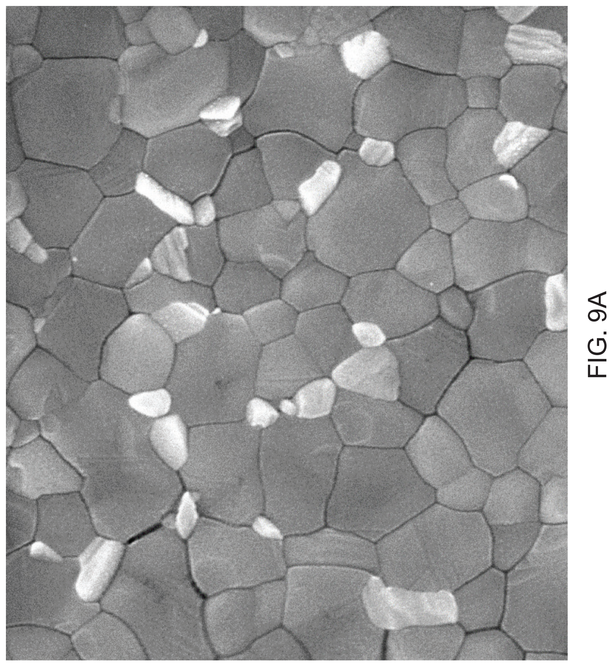

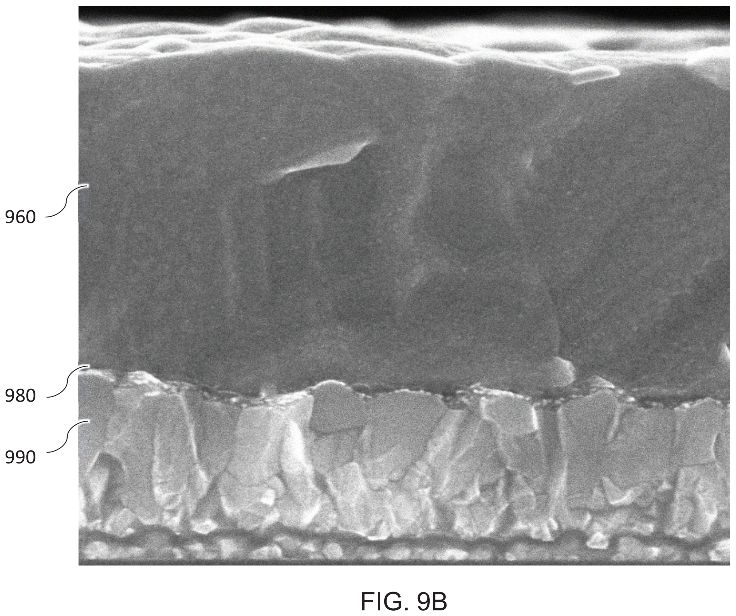

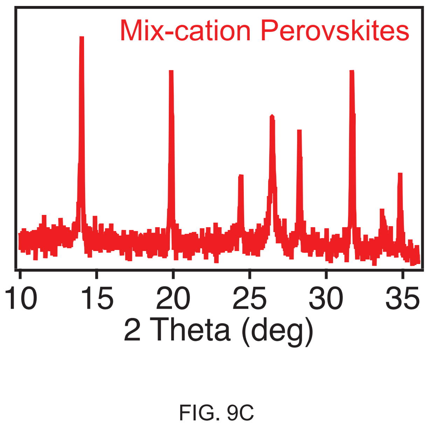

FIGS. 9A and 9B show SEM images of a segment of a P-I-N structured partly-formed device with a bilayer HTL, including a NiOx first sublayer and a P3HT-COOH second sublayer. The HTL bilayer 980 is formed over a front contact TCO layer 990. The perovskite absorber layer 960 is formed over the P3HT-COOH second sublayer of the bilayer HTL 980. FIG 9A is a surface view, showing the densely packed and well-formed top surface of the perovskite absorber layer before deposition of an ETL. FIG. 9B is a cross-section view showing the front interface of the perovskite absorber, which is substantially defect free, without porousness. FIG. 9 C shows XRD characterization of the partly-formed device formed with perovskite over the HTL bilayer 980.

As shown in FIGS. 9A-9C, high-quality, compact and continuous perovskite absorber layer can be obtained due to favorable interfaces between the second sublayer, P3HT-COOH, and the perovskite and its precursor materials. This is due in-part to the hydrophobic nature of P3HT-COOH, as indicated by contact angle. The data show good conversion to perovskite, with no precursor peaks (PbI₂, MAI, FAI) observed in XRD, indicating the complete conversion from precursor to cubic phase perovskite materials. The perovskite signature peaks are sharp with high intensity, indicating a high-quality perovskite absorber. SEM imaging shows well-defined, large, and substantially uniform perovskite grains. The surface morphology in the perovskite thin film is smooth and compact, resulting in a uniform ETL layer and electrode, which is beneficial for electron extraction. The cross-sectional SEM shows defect-free morphologies in the perovskite layer.

The exact thickness of the second sublayer, including PTAA and P3HT-COOH, is difficult to measure with conventional tools and may be non-conformal with the presence of pinholes. The P3HT-COOH sublayer in FIGS. 9A-9C is less than 4 nm, and it is estimated that the thickness of the organic sublayer ranges from several angstroms to a few tens of angstroms, or in a range of about 0.3 nm to about 3.5 nm. While SEM imaging of the second sublayer is challenging, the presence of the second sublayer, or organic layer can be confirmed by contact angle measurement.

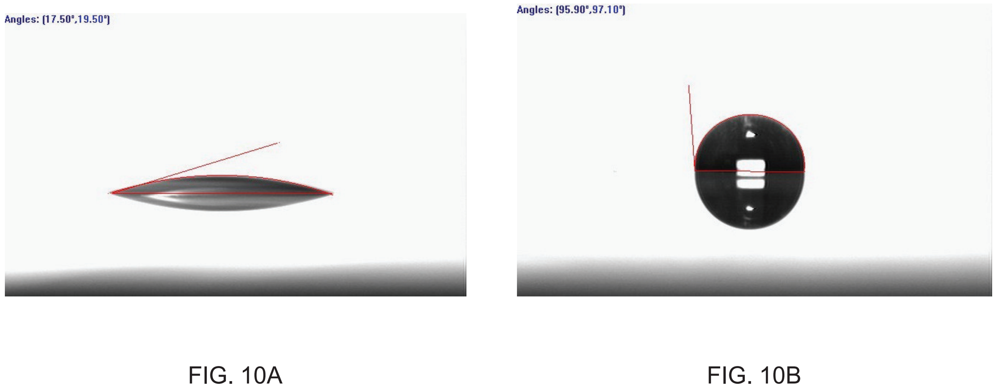

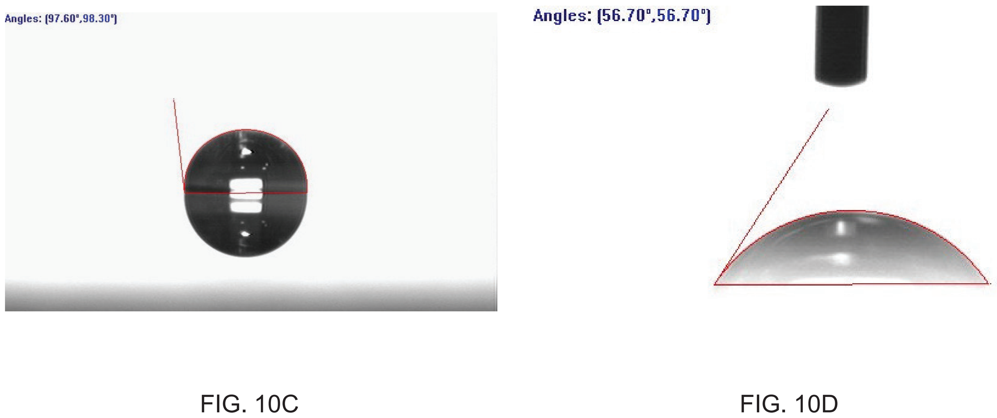

Contact angle measurement can be used to measure material characteristics with respect to hydrophobic or hydrophilic properties. Contact angle measurements can be prepared using water droplets or with non-water solvents, such as DMF. FIGS. 10A-10D show contact angle measurements of water on selected materials. FIG. 10A shows a contact angle of about 18° for water on a NiOx film, indicating that the material is relatively hydrophilic. FIG. 10B shows a contact angle of about 96° for water on a bilayer film of NiOx overlaid by PTAA, formed by solution processing at a concentration of 0.5mg/mL; the steep angle indicates that the bilayer surface is hydrophobic. FIG. 10C shows a contact angle of about 98° for water on a bilayer film of NiOx overlaid by PTAA, formed by solution processing at a concentration of 1.0mg/mL; the steep angle indicates that the bilayer surface is very hydrophobic. FIG. 10D shows a contact angle of about 57° for water on a bilayer film of NiOx overlaid by P3HT-COOH, the angle indicates that the bilayer surface is semi-hydrophobic.

Addition of an organic layer over an inorganic or organometallic layer may be used to modify the hydrophobicity of the hole transport layer surface and may reduce surface roughness. Perovskite layer uniformity and quality may be enhanced by depositing the perovskite material, or perovskite precursor material, over and directly onto a surface that has low roughness and that is hydrophobic or semi-hydrophobic. A semi-hydrophobic surface may have a water contact angle from 45° to 90° and a hydrophobic surface may have a water contact angle of 90° or greater.

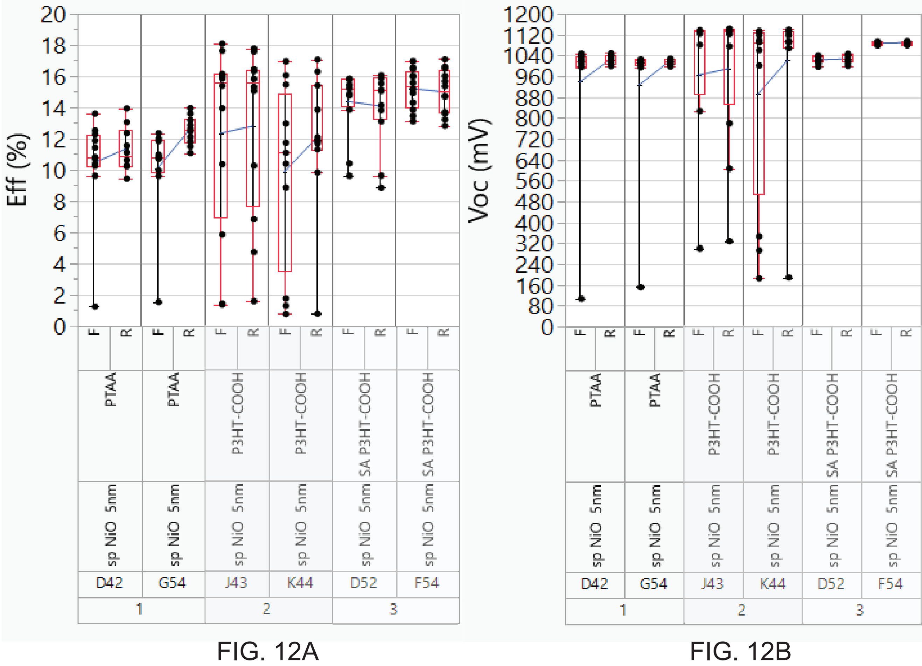

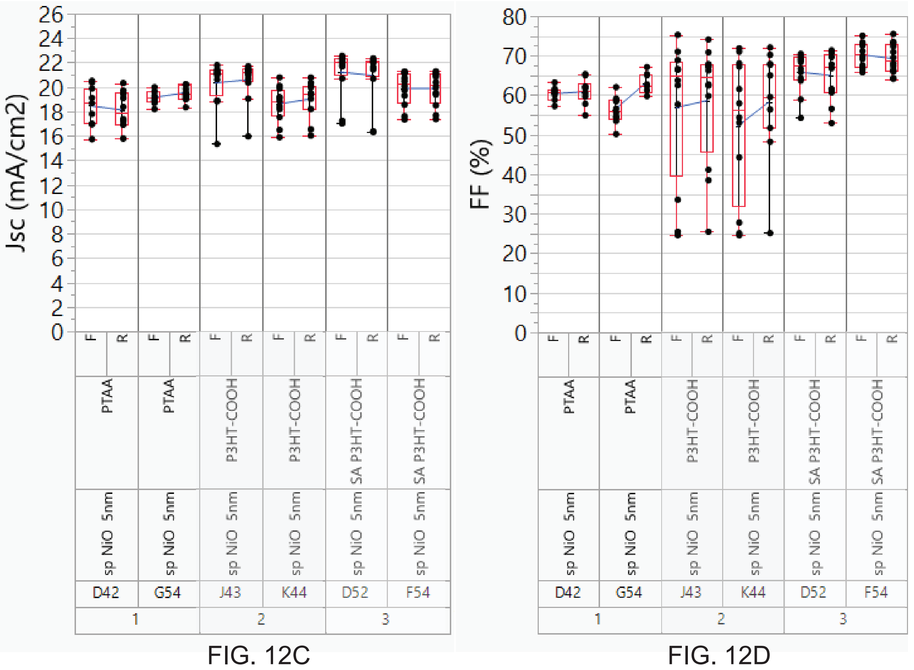

FIGS. 12A-12D show device performance characteristics for experimental structures, with a bilayer HTL of NiOx and P3HT-COOH, and controls, with a NiOx HTL, formed by a one-step process. The performance data includes measurements of efficiency, open-circuit voltage (Voc), fill factor (FF), and short-circuit current density (Jsc).

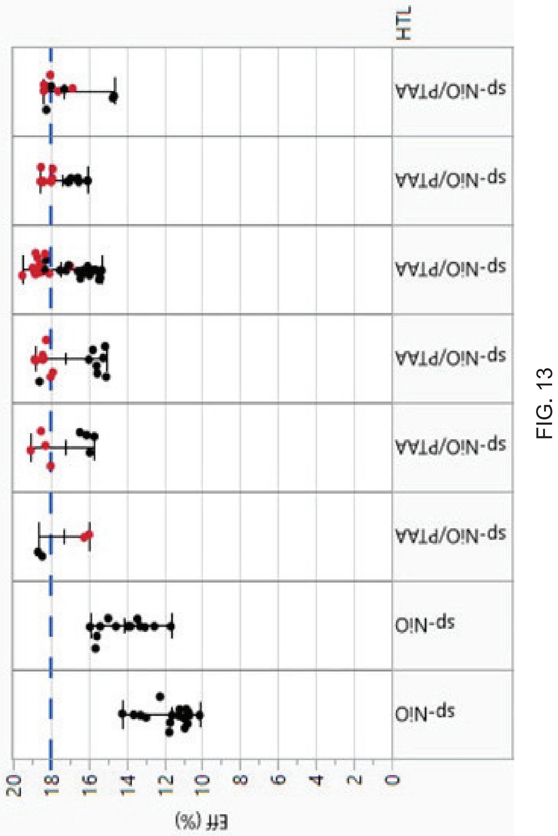

FIG. 13 shows performance for experimental devices having a NiO/PTAA bilayer HTL structure and controls with a NiO HTL. Each column includes a set of devices prepared on a single date. The results show that the devices had good performance values with reliable performance reproducibility between devices produced in different batches.

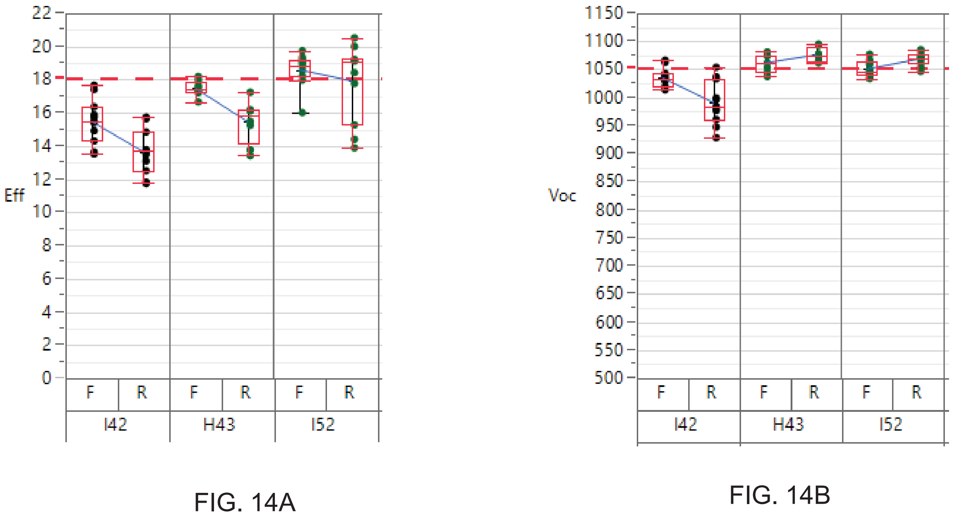

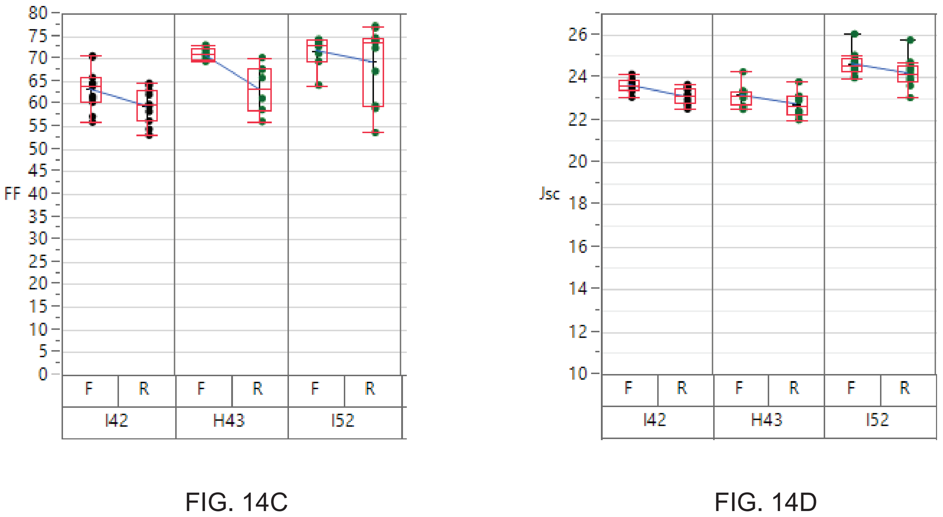

FIGS. 14A-14D show device performance characteristics for experimental structures with a NiOx/PTAA bilayer. The devices have a NiO/PTAA bilayer HTL structure. The structures shown in the left two columns were additionally subjected to treatment for defect passivation. FIG. 14A shows efficiency; FIG. 14B shows Voc; FIG. 14C shows fill factor; and FIG. 14D shows short-circuit current density. The results show that the devices had good performance values with reliable performance reproducibility.

Materials for the first HTL sublayer and second HTL sublayer can be selected with respect to adjacent layers or layer precursors. Materials, including dopants, may be selected for factors including charge carrier properties, work function, band gap, or hydrophobicity. Surface treatment or passivation may be included before or after application of coatings. In some embodiments, the method produces a device having more effective charge extraction and transport, reduced interfacial recombination losses, and enhanced band alignment. In some embodiments, the method produces a device that controls and mitigates perovskite degradation.

According to the embodiments provided herein, a hole transport layer for a perovskite device may include a first HTL sublayer and a second HTL sublayer.

In some embodiments, the hole transport layer is a bilayer consisting essentially of a first hole transport material and a second hole transport material.

In some embodiments, the hole transport layer is a hole transport stack formed by at least two distinct materials where one or both of the layers in the stack is less than 10 nm thick. In some embodiments, the hole transport layer is a hole transport stack comprising a first HTL sublayer and a second HTL sublayer.

In some embodiments, the perovskite device is formed in P-I-N orientation and the second HTL sublayer is formed over the first HTL sublayer.

In some embodiments, the perovskite device is formed in N-I-P orientation and the first HTL sublayer is formed over the second HTL sublayer.

In some embodiments, the first HTL sublayer comprises a layer of NiOx, WO₃, CuPc, or CuSCN, having a thickness in a range of 4-100 nm, and the second HTL sublayer comprises an ultra thin layer of PTAA, undoped Spiro-OMeTAD, P3HT, P3HT-COOH, or Poly-TPD, having a thickness in a range of 5-100 angstroms.

In some embodiments a second HTL sublayer comprises a carbazole-based self-assembled monolayer comprising at least one of: 2PACz, MeO-2PACz, or Me-4PACz.

In some embodiments a hole transport layer for a perovskite device may include a self-assembled monolayer between an oxide layer and a PTAA layer. In some embodiments the self-assembled monolayer is adjacent to an oxide layer and an organic HTM. In an example, the self-assembled monolayer is MeO-2PACz in a HTL structure of TCO/MeO-2PACz/PTAA. In some embodiments, the hole transport layer is a hole transport stack comprising a first HTL sublayer, a second HTL sublayer, and a third HTL sublayer. In some embodiments, a third HTL sublayer consists essentially of a self-assembled monolayer. In some embodiments, a third HTL sublayer is disposed between a first HTL sublayer and a second HTL sublayer. In some embodiments a third HTL sublayer comprises a carbazole based self-assembled monolayer such as 2PACz, MeO-2PACz, or Me-4PACz.

In some embodiments, the hole transfer layer comprises at least two hole transfer materials selected from: a polymer HTM, a small molecule HTM, organometallic HTM compound, or an inorganic HTM compound. In some embodiments, the hole transfer material comprises a polymer selected from: PTAA, P3HT, P3HT-COOH, or PEDOT:PSS. In some embodiments, the hole transfer material comprises a small molecule selected from: Spiro-OMeTAD, SAF-OMe, OMeTPA-FA, or TTF-1. In some embodiments, the hole transfer material comprises an organometallic HTM compound selected from: copper thiocyanate or copper pthalocyanine. In some embodiments, the hole transfer material comprises an inorganic compound selected from nickel oxide, copper oxide, copper indium sulfide, copper chromium iodide, copper iodide, vanadium oxide, zinc telluride, cobalt zinc oxide, or tungsten oxide.

In some embodiments, the first HTL sublayer comprises an inorganic compound or organometallic compound selected from NiOx, CuSCN, CuPc, CuI, or Cu₂O.

In some embodiments, the second sublayer is hydrophobic. In some embodiments, the second sublayer has a water contact angle greater than 45°. In some embodiments, the second sublayer has a water contact angle greater than 50°. In some embodiments, the second sublayer has a water contact angle in a range of 45°-110°. In some embodiments, the second sublayer has a water contact angle in a range of 50°-110°.

According to the embodiments provided herein, a photovoltaic device may comprise: a transparent conductive oxide; and a multilayer hole transport stack over the transparent conductive oxide. The multilayer hole transport stack may comprise a thin hole transport layer over a thick hole transport layer. The thin hole transport layer may comprise an organic hole transport material. The thick hole transport layer may comprise an inorganic hole transport material or an organometallic hole transport material. The thick hole transport layer may be at least twice the thickness of the thin hole transport layer. The photovoltaic device may include a perovskite absorber layer over the multilayer hole transport stack, with the thin hole transport layer of the multilayer hole transport stack adjacent to the perovskite absorber layer.

In some embodiments, the thick hole transport layer has a thickness in a range of 4.0 nm to 100 nm; and the thin hole transport layer has a thickness in a range of 0.3 nm to 4.0 nm.

In some embodiments, the thick hole transport layer, or first sublayer, is at least two times thicker than the thin hole transport layer, or second sublayer. In some embodiments, the thick hole transport layer, or first sublayer, is at least four times thicker than the thin hole transport layer, or second sublayer. In some embodiments, a ratio of the thickness of the thick hole transport layer to the thickness of the thin hole transport layer is in a range from 2:1 to 100:1.

In some embodiments, the thick hole transport layer includes at least one of a metal oxide, a metal nitride, or a metal oxynitride.

According to the embodiments provided herein, a hole transport stack for a perovskite photovoltaic device may comprise a first sublayer, including a first hole transport material; and a second sublayer, including a second hole transport material. In some embodiments, the first hole transport material comprises an inorganic hole transport material or an organometallic hole transport material. In some embodiments, the second hole transport material comprises an organic hole transport material. In some embodiments, the first sublayer is configured to be adjacent to a p-type contact layer of the photovoltaic device. In some embodiments, the second sublayer is adjacent to the first sublayer. In some embodiments, the second sublayer is configured to be adjacent to a perovskite absorber layer in the photovoltaic device; and the first sublayer is at least four times the thickness of the second sublayer.

In some embodiments, the first sublayer has a thickness in a range of 4.0 nm to 100 nm; and the second sublayer has a thickness in a range of 0.3 nm to 4.0 nm.

In some embodiments, the first sublayer, or the thick hole transport layer, has a thickness in a range of 4.0 nm to 100 nm. In some embodiments, the first sublayer has a thickness in a range of 0.1 nm to 150 nm. In some embodiments, the first sublayer has a thickness in a range of 0.5 nm to 100 nm, 1.0 nm to 100 nm, 4.0 nm to 100 nm, 0.5 nm to 50 nm, 1.5 nm to 50 nm, 2.0 nm to 50 nm, 4.0 nm to 50 nm, 0.5 nm to 25 nm, 1.5 nm to 25 nm, 2.0 nm to 25 nm, 4.0 nm to 25 nm, or 2 nm to 20 nm.

In some embodiments, the second sublayer, or the thin hole transport layer, has a thickness in a range of 0.3 nm to 10 nm. In some embodiments, the second sublayer has a thickness in a range of 0.3 nm to 4.0 nm. In some embodiments, the second sublayer has a thickness in a range of 0.5-10 nm, 0.5-8.0 nm, 0.5-5.0 nm, 0.5-3.0 nm, 0.5-2.0 nm, 0.5-1.0 nm, 1.0-10.0 nm, 1.0-8.0 nm, 1.0-5.0 nm, 1.0-3.0 nm, or 1.0-2.0 nm.

In some embodiments, a ratio of the thickness of the first, thicker sublayer to the thickness of the second, thinner sublayer is in a range from 2:1 to 100:1. In some embodiments, a ratio of the thickness of the first sublayer to the thickness of the second sublayer is in a range of in a range of 4:1 to 100:1, in a range of 2:1 to 10:1, in a range of 5:1 to 100:1, in a range of 10:1 to 100:1, in a range of 15:1 to 100:1, in a range of 20:1 to 100:1, in a range of 15:1 to 100:1, or in a range of 5:1 to 80:1. In some embodiments, the thin layer or second sublayer is deposited as a substantially self-assembled monolayer film.

In some embodiments, a band gap of the first HTM is greater than a band gap of the second HTM.

In some embodiments, the organic HTM includes at least one of: PTAA, P3HT, P3HT-COOH, poly-TPD, PEDOT:PSS, Spiro-OMeTAD, SAF-OMe, OMeTPA-FA, SGT-407, Fused-F, TTF-1, alpha-NPD, TIPS-pentacene, PCPDTBT, PCDTBT, or quinolizino acridine. In some embodiments, the organic HTM includes at least one of PTAA, P3HT, P3HT-COOH, poly-TPD, Spiro-OMeTAD, SAF-OMe, OMeTPA-FA, or TTF-1. In some embodiments, the organic HTM consists essentially of PTAA. In some embodiments, the organic HTM consists essentially of P3HT. In some embodiments, the organic HTM consists essentially of poly-TPD. In some embodiments, the organic HTM consists essentially of un-doped Spiro-OMeTAD.

In some embodiments, the first hole transport material includes at least one of: nickel oxide (NiOₓ), copper thiocyanate (CuSCN), copper phthalocyanine (CuPc), tungsten oxide (WO₃), copper iodide (CuI), copper oxide (CuOₓ), copper indium disulfide (CuInS₂), chromium oxide (CrOₓ), copper chromium iodide (CuCrIx), molybdenum oxide (MoOₓ), vanadium oxide (V₂O₅), cobalt oxide (CoOₓ), nickel phthalocyanine (NiPc), aluminum oxide (Al₂O₃), or zinc telluride (ZnTe).

In some embodiments, a partly-formed photovoltaic device comprises: the p-type contact layer over a substrate; the first sublayer over the p-type contact; and the second sublayer over the first sublayer; wherein the second sublayer has an exposed surface that is hydrophobic or semi-hydrophobic, whereby a contact angle for water on the exposed surface is between 45° to 120°.

According to the embodiments provided herein, a method for forming a perovskite photovoltaic device may include: providing a substrate stack, the substrate stack having a transparent p-type contact layer; forming a first hole transport sublayer over the transparent contact layer; forming a second hole transport sublayer over the first hole transport sublayer; and forming a perovskite absorber layer adjacent to the second hole transport sublayer.

In some embodiments, the method further comprises forming an ETL over the perovskite absorber layer and forming a contact layer over the ETL.

In some embodiments, the step of depositing the second hole transport sublayer comprises at least one of: spin coating, slot coating, spray coating, blade coating, or dip coating.

In some embodiments, a hole transport material for the second sublayer includes one or more of PTAA, P3HT, P3HT-COOH, or PEDOT:PSS. In some embodiments, the second sublayer consists essentially of PTAA or P3HT-COOH,.

In some embodiments, a hole transport material for the second sublayer includes one or more of Spiro-OMeTAD, SAF-OMe, OMeTPA-FA, or TTF-1. In some embodiments, the second sublayer consists essentially of undoped Spiro-OMeTAD.

In some embodiments, a device produced by the method has an efficiency greater than 16%, 17%, or 18%, or the efficiency is in a range of 16% to 25%.

Certain embodiments of the devices, apparatuses, and methods disclosed herein are defined in the above examples. It should be understood that these examples, while indicating particular embodiments, are given by way of illustration only. From the above discussion and these examples, one skilled in the art can ascertain the essential characteristics of this disclosure, and without departing from the spirit and scope thereof, can make various changes and modifications to adapt the compositions and methods described herein to various usages and conditions. Various changes may be made and equivalents may be substituted for elements thereof without departing from the essential scope of the disclosure. In addition, many modifications may be made to adapt a particular situation or material to the teachings of the disclosure without departing from the essential scope thereof.
Features and embodiments of the present invention will now be described with reference to the following numbered paragraphs (paras).
1. A photovoltaic device comprising:
   a transparent conductive oxide;
   a multilayer hole transport stack over the transparent conductive oxide, the multilayer hole transport stack comprises a thin hole transport layer over a thick hole transport layer, wherein:
      the thin hole transport layer comprises an organic hole transport material,
      the thick hole transport layer comprises an inorganic hole transport material or an organometallic hole transport material, and
      the thick hole transport layer is at least two times the thickness of the thin hole transport layer; and
   a perovskite absorber layer over the multilayer hole transport stack, wherein:
      the thin hole transport layer of the multilayer hole transport stack directly contacts the perovskite absorber layer.
2. The photovoltaic device of para 1, wherein:
   the thick hole transport layer has a thickness in a range of 4.0 nm to 100 nm; and
   the thin hole transport layer has a thickness in a range of 0.3 nm to 4.0 nm.
3. The photovoltaic device of para 1, wherein a ratio of the thickness of the thick hole transport layer to the thickness of the thin hole transport layer is in a range from 4:1 to 100:1.
4. The photovoltaic device of para 1, wherein the organic hole transport material includes at least one of PTAA, P3HT, P3HT-COOH, poly-TPD, PEDOT:PSS, Spiro-OMeTAD, SAF-OMe, OMeTPA-FA, SGT-407, Fused-F, TTF-1, alpha-NPD, TIPS-pentacene, PCPDTBT, PCDTBT, polyelectrolyte (P3CT-N, P3CT-Rb), spiro[fluorene-9,9' -xanthene] (SFX)-based 3D oligomers (X55), carbazole based self-assembled monolayer (2PACz, MeO-2PACz, Me-4PACz), or quinolizino acridine.
5. The photovoltaic device of para 1, wherein the organic material includes at least one of PTAA, P3HT, P3HT-COOH, poly-TPD, or undoped Spiro-OMeTAD.
6. The photovoltaic device of para 1, wherein the thick hole transport layer includes at least one of a metal oxide, a metal nitride, or a metal oxynitride.
7. The photovoltaic device of para 1, wherein the thick hole transport layer includes at least one of: nickel oxide (NiOₓ), copper thiocyanate (CuSCN), copper phthalocyanine (CuPc), tungsten oxide (WO₃), copper iodide (CuI), copper oxide (CuOₓ), copper sulfide (CuS), copper indium disulfide (CuInS₂), chromium oxide (CrOx), copper chromium iodide (CuCrIx), molybdenum oxide (MoOx), vanadium oxide (V₂O₅), cobalt oxide (CoOx), nickel phthalocyanine (NiPc), aluminum oxide (Al₂O₃), or zinc telluride (ZnTe).
8. A hole transport stack for a perovskite photovoltaic device comprising:
   a first sublayer, comprising a first hole transport material; and
   a second sublayer, comprising a second hole transport material;
   wherein:
   the first hole transport material comprises an inorganic hole transport material or an organometallic hole transport material;
   the second hole transport material comprises an organic hole transport material;
   the first sublayer is configured to be adjacent to a p-type contact layer of the photovoltaic device;
   the second sublayer is adjacent to the first sublayer;
   the second sublayer is configured to be adjacent to a perovskite absorber layer in the photovoltaic device; and
   the first sublayer is at least two times the thickness of the second sublayer.
9. The hole transport stack of para 8, wherein:
   the first sublayer has a thickness in a range of 4.0 nm to 100 nm; and
   the second sublayer has a thickness in a range of 0.3 nm to 4.0 nm.
10. The hole transport stack of para 8, wherein a ratio of the thickness of the first sublayer to the thickness of the second sublayer is in a range from 4:1 to 100:1.
11. The hole transport stack of para 8, wherein the second hole transport material includes at least one of PTAA, P3HT, P3HT-COOH, poly-TPD, PEDOT:PSS, Spiro-OMeTAD, SAF-OMe, OMeTPA-FA, SGT-407, Fused-F, TTF-1, alpha-NPD, TIPS-pentacene, PCPDTBT, PCDTBT, polyelectrolyte (P3CT-N, P3CT-Rb), spiro[fluorene-9,9' -xanthene] (SFX)-based 3D oligomers (X55), carbazole based self-assembled monolayer (2PACz, MeO-2PACz, Me-4PACz), or quinolizino acridine.
12. The hole transport stack of para 8, wherein the organic hole transport material includes at least one of PTAA, P3HT, P3HT-COOH, poly-TPD, or undoped Spiro-OMeTAD.
13. The hole transport stack of para 8, wherein:
   the first hole transport material includes at least one of: nickel oxide (NiOₓ), copper thiocyanate (CuSCN), copper phthalocyanine (CuPc), tungsten oxide (WO₃), copper iodide (CuI), copper oxide (CuOₓ), copper sulfide (CuS), copper indium disulfide (CuInS₂), chromium oxide (CrOₓ), copper chromium iodide (CuCrI_{X}), molybdenum oxide (MoOₓ), vanadium oxide (V₂O₅), cobalt oxide (CoOₓ), nickel phthalocyanine (NiPc), aluminum oxide (Al₂O₃), or zinc telluride (ZnTe).
14. The hole transport stack of para 8, wherein a partly-formed photovoltaic device comprises:
   the p-type contact layer over a substrate;
   the first sublayer over the p-type contact layer; and
   the second sublayer over the first sublayer;
   wherein the second sublayer has an exposed surface that is hydrophobic or semihydrophobic,
   whereby a contact angle for water on the exposed surface is between 45° to 120°.
15. The hole transport stack of para 8, wherein a band gap of the first hole transport material is greater than a band gap of the second hole transport material.
16. A method of forming a perovskite photovoltaic device comprising:
   providing a substrate stack, the substrate stack having a transparent p-type contact layer;
   forming a first sublayer comprising a first hole transport material over the p-type contact layer;
   forming a second sublayer comprising a second hole transport material over the first sublayer; wherein a ratio of the thickness of the first sublayer to the thickness of the second
      sublayer is in a range from 2:1 to 100:1; and
   forming a perovskite absorber layer adjacent to the second sublayer.
17. The method of para 16, wherein the step of forming the second hole transport sublayer comprises at least one of: spin coating, slot coating, spray coating, blade coating, or dip coating.
18. The method of para 16, wherein:
   the first hole transport material comprises nickel oxide (NiOₓ);
   the second hole transport material includes at least one of PTAA, P3HT, or P3HT-COOH; and
   a ratio of the thickness of the first sublayer to the thickness of the second sublayer is in a range from 3:1 to 10:1.
19. The method of making the hole transport stack of any one of paras 1-15, comprising the steps of any one of paras 16-18.
20. A hole transport stack for a perovskite photovoltaic device comprising:
   a first sublayer, comprising a first hole transport material; and
   a second sublayer, comprising a second hole transport material;
   wherein:
      the first hole transport material is a different material from the second hole transport material.
21. The hole transport stack of para 8 or 20, wherein
   The first sublayer layer is less than 10 nm thick.
22. The hole transport stack of para 8 or 20-21, wherein
   The second sublayer is less than 10 nm thick.
23. The hole transport stack of para 8 or 20-22, wherein the second sublayer contacts a perovskite absorber layer of the perovskite photovoltaic device.
24. The hole transport stack of para 8 or 20-23, comprising a third sublayer, wherein the third sublayer is less than 10 nm thick.
25. The hole transport stack of para 24, wherein the third sublayer is between the first sublayer and the second sublayer.
26. The hole transport stack of para 24-25, wherein the third sublayer comprises at least one of 2PACz, MeO-2PACz, or Me-4PACz.
27. The hole transport stack of para 8 or 20-26, wherein the second sublayer comprises a carbazole-based self-assembled monolayer.
28. The hole transport stack of para 8 or paras 20-26, wherein the second sublayer comprises at least one of PTAA, P3HT, P3HT-COOH, poly-TPD, PEDOT:PSS, 2PACz, MeO-2PACz, or Me-4PACz.
29. The hole transport stack of para 8 or paras 20-26, wherein the second sublayer comprises PTAA.
30. The hole transport stack of para 8 or paras 20-26, wherein the second sublayer comprises P3HT.
31. The hole transport stack of para 8 or paras 20-26, wherein the second sublayer comprises P3HT-COOH.
32. The hole transport stack of para 8 or paras 20-26, wherein the second sublayer comprises poly-TPD.
33. The hole transport stack of para 8 or paras 20-26, wherein the second sublayer comprises PEDOT:PSS.
34. The hole transport stack of para 8 or paras 20-26, wherein the second sublayer comprises 2PACz.
35. The hole transport stack of para 8 or paras 20-26, wherein the second sublayer comprises MeO-2PACz.
36. The hole transport stack of para 8 or paras 20-26, wherein the second sublayer comprises Me-4PACz.
37. The hole transport stack of para 8 or paras 20-36, wherein the first sublayer comprises at least one of: nickel oxide (NiOₓ), copper thiocyanate (CuSCN), copper phthalocyanine (CuPc), tungsten oxide (WO₃), copper iodide (CuI), copper oxide (CuOₓ), copper sulfide (CuS), copper indium disulfide (CuInS₂), chromium oxide (CrOₓ), copper chromium iodide (CuCrI_{X}), molybdenum oxide (MoOₓ), vanadium oxide (V₂O₅), cobalt oxide (CoOₓ), nickel phthalocyanine (NiPc), aluminum oxide (Al₂O₃), or zinc telluride (ZnTe).
38. The hole transport stack of para 8 or paras 20-36, wherein the first sublayer comprises nickel oxide (NiOₓ).
39. The hole transport stack of para 8 or paras 20-36, wherein the first sublayer comprises copper thiocyanate (CuSCN), copper phthalocyanine (CuPc), copper iodide (CuI), copper oxide (CuOₓ), copper sulfide (CuS), copper indium disulfide (CuInS₂), or copper chromium iodide (CuCrI_{X}).
40. The hole transport stack of para 8 or paras 20-36, wherein the first sublayer comprises tungsten oxide (WO₃).
41. The hole transport stack of para 8 or paras 20-36, wherein the first sublayer comprises chromium oxide (CrOₓ).
42. The hole transport stack of para 8 or paras 20-36, wherein the first sublayer comprises molybdenum oxide (MoOₓ).
43. The hole transport stack of para 8 or paras 20-36, wherein the first sublayer comprises vanadium oxide (V₂O₅).
44. The hole transport stack of para 8 or paras 20-36, wherein the first sublayer comprises cobalt oxide (CoOₓ).
45. The hole transport stack of para 8 or paras 20-36, wherein the first sublayer comprises nickel phthalocyanine (NiPc).
46. The hole transport stack of para 8 or paras 20-36, wherein the first sublayer comprises aluminum oxide (Al₂O₃).
47. The hole transport stack of para 8 or paras 20-36, wherein the first sublayer comprises zinc telluride (ZnTe).
48. A photovoltaic device comprising the hole transport stack of any of para 8 or paras 20-47.

## Claims

1. A photovoltaic device comprising:
a conducting layer (190) comprising a transparent conductive oxide;
a multilayer hole transport stack (180) over the transparent conductive oxide, the multilayer hole transport stack comprising:
a first sublayer (310), comprising a first hole transport material;
a second sublayer (320), comprising a second hole transport material; wherein:
the first sublayer (310) comprises an inorganic hole transport material;
the first hole transport material is a different material from the second hole transport material;
the first sublayer (310) is at least two times the thickness of the second sublayer (320); and
a perovskite absorber layer over the multilayer hole transport stack (180), wherein:
the second sublayer (320) of the multilayer hole transport stack directly contacts the perovskite absorber layer.

2. The photovoltaic device of claim 1, wherein:
the first sublayer (310) has a thickness in a range of 4.0 nm to 100 nm;
the second hole transport material comprises at least one of: PTAA, P3HT, P3HT-COOH, poly-TPD, PEDOT:PSS, 2PACz, MeO-2PACz, or Me-4PACz, or a carbazole-based self-assembled monolayer; and
the multilayer hole transport stack (180) further comprises a third sublayer, wherein the third sublayer is between the first sublayer (310) and the second sublayer (320), and the third sublayer is less than 10 nm thick.

3. The photovoltaic device of claim 1 or claim 2, wherein the first hole transport material of the first sublayer (310) is doped with at least one element selected from: Cu, Li, K, Cs, Mg, Ca, Sr, Ba Eu, Tb, or Er.

4. The photovoltaic device of any one of claims 1-3, wherein the multilayer hole transport stack (180) comprises the inorganic hole transport material and a hole transfer material (HTM) selected from: a polymer HTM, a small molecule HTM, or an organometallic HTM compound.

5. The photovoltaic device of any one of claims 1-4, wherein the second hole transport material includes at least one of: PTAA, P3HT, P3HT-COOH, poly-TPD, or undoped Spiro-OMeTAD.

6. The photovoltaic device of any one of claims 1-4, wherein the second hole transport material comprises 2PACz.

7. The photovoltaic device of any of claims 1-6, wherein:
the first hole transport material includes at least one of: a metal oxide, a metal nitride, or a metal oxynitride; and
the photovoltaic device comprises a buffer layer, wherein the buffer layer comprises: tin dioxide, zinc magnesium oxide, silicon dioxide, aluminum oxide, aluminum nitride, zinc tin oxide, zinc oxide, tin silicon oxide, or combinations thereof.

8. A method of forming a perovskite photovoltaic device having a multilayer hole transport stack comprising:
providing a substrate stack, the substrate stack comprising a conducting layer;
forming a first sublayer comprising a first hole transport material over the conducting layer;
forming a second sublayer comprising a second hole transport material over the first sublayer; wherein:
the multilayer hole transport stack comprises the first sublayer and the second sublayer;
the first hole transport material comprises an inorganic hole transport material;
the first hole transport material is a different material from the second hole transport material; and
a ratio of the thickness of the first sublayer to the thickness of the second sublayer is in a range from 2:1 to 100:1; and
forming a perovskite absorber layer adjacent to the second sublayer.

9. The method of claim 8, wherein the step of forming the second sublayer comprises at least one of: spin coating, slot coating, spray coating, inkjet printing, blade coating, or dip coating.

10. The method of claim 8 or claim 9, wherein:
the first hole transport material comprises nickel oxide (NiOₓ);
the second hole transport material includes at least one of PTAA, P3HT, or P3HT-COOH; and
a ratio of the thickness of the first sublayer to the thickness of the second sublayer is in a range from 3:1 to 10:1.

11. The method of any one of claims 8-10, wherein: the first hole transport material is doped with at least one element selected from: Cu, Li, K, Cs, Mg, Ca, Sr, Ba Eu, Tb, or Er.

12. The method of any one of claims 8-11, further comprising: forming a third sublayer between the first sublayer (310) and the second sublayer (320), wherein the third sublayer is less than 10 nm thick.

13. The method of claim 12, wherein the third sublayer comprises at least one of: 2PACz, MeO-2PACz, or Me-4PACz.

14. The method of any one of claims 8-11, wherein:
the second sublayer comprises at least one of: PTAA, P3HT, P3HT-COOH, poly-TPD, PEDOT:PSS, or a carbazole-based self-assembled monolayer; and
the multilayer hole transport stack (180) further comprises a third sublayer.

15. The method of any one of claims 8-14, wherein: the step of forming a first sublayer comprises annealing at a temperature in a range of 200° C to 500° C.
